# EUROPÄISCHE PATENTSCHRIFT

(11) **EP 3 607 451 B1**
(45) Veröffentlichungstag und Bekanntmachung des Hinweises auf die Patenterteilung: **03.05.2023**
(21) Anmeldenummer: 18714677.4
(22) Anmeldetag: 13.03.2018
(51) Int. Cl.: G06F 13/40, H01R 31/08, H01R 13/518

(54) **STECKVERBINDERMODULARSYSTEM MIT INTEGRIERTEM DATENBUS**
MODULAR PLUG SYSTEM COMPRISING AN INTEGRATED DATA BUS
SYSTÈME MODULAIRE DE CONNECTEURS ENFICHABLES COMPORTANT UN BUS DE DONNÉES INTÉGRÉ

(30) Priorität: 03.04.2017 DE 102017003198
(43) Veröffentlichungstag der Anmeldung: 12.02.2020
(73) Patentinhaber: Harting Electric GmbH & Co. KG, 32339 Espelkamp (DE)
(72) Erfinder: VOLLMER, Christian, 30051 Herford (DE); FRIESEN, Markus, 32339 Espelkamp (DE)
(86) Internationale Anmeldenummer: PCT/DE2018/100225
(87) Internationale Veröffentlichungsnummer: WO 2018/184627

(56) Entgegenhaltungen:
- EP-A1- 3 065 348
- WO-A2-2015/149757
- US-A1- 2010 250 805
- US-A1- 2012 072 626
- US-A1- 2016 269 194

## Beschreibung

Die Erfindung geht aus von einem Steckverbindermodularsystem nach der Gattung des unabhängigen Anspruchs 1.

Weiterhin geht die Erfindung aus von einem Messverfahren nach der Gattung des unabhängigen Anspruchs 11.

Derartige Steckverbindermodularsysteme werden benötigt, um einen Steckverbinder, insbesondere einen schweren Rechtecksteckverbinder, flexibel an bestimmte Anforderungen bezüglich der Signal- und Energieübertragung, z. B. zwischen zwei elektrischen Geräten, anpassen zu können.

### Stand der Technik

Im Stand der Technik sind Steckverbindermodularsysteme unter Verwendung eines Modularrahmens, auch als Halterahmen oder Modulrahmen bekannt, in zahlreichen Druckschriften und Veröffentlichungen offenbart, auf Messen gezeigt und befinden sich insbesondere im industriellen Umfeld in Form von Schwerlaststeckverbindern im Einsatz. Beispielsweise werden sie in den Druckschriften DE 10 2013 106 279 A1, DE 10 2012 110 907 A1, DE 10 2012 107 270 A1, DE 20 2013 103 611 U1, EP 2 510 590 A1, EP 2 510 589 A1, DE 20 2011 050 643 U1, EP 860 906 A2, DE 29 601 998 U1, EP 1 353 412 A2, DE 10 2015 104 562 A1, EP 3 067 993 A1, EP 1 026 788 A1, EP 2 979 326 A1, EP 2 917 974 A1 beschrieben. Dabei werden in der Regel mehrere gleiche oder verschiedene Steckverbindermodule gemeinsam in einem Modularrahmen gehalten und in ein Steckverbindergehäuse eingebaut. Die Funktion eines dadurch gebildeten Steckverbinders ist also sehr flexibel. Es können z. B. pneumatische Module, optische Module, Module zur Übertragung elektrischer Energie und/oder elektrischer analoger und/oder digitaler Signale im Steckverbindermodularsystem Verwendung finden. Zunehmend übernehmen Steckverbindermodule auch mess- und datentechnische Aufgaben.

Die Druckschrift US 2016/0269194 A1 offenbart Systeme und Methoden, um Geräte von Pool- und Spa-Systemen in einem Kommunikationsnetzwerk automatisch zu adressieren. Das Kommunikationsnetz umfasst mindestens einen ersten Transceiver und einen zweiten Transceiver, die über einen Kommunikationsnetzbus kommunikativ gekoppelt sind. Der erste Transceiver ist konfiguriert, um ein Abfragesignal an den zweiten Transceiver an einer ersten Adresse auf dem Kommunikationsnetzwerkbus zu senden, wobei das Abfragesignal einen Befehl enthält, der Identifikationsdaten (z. B. eine Seriennummer) anfordert, die dem zweiten Transceiver vom zweiten Transceiver zugeordnet sind. Nach dem Empfang einer Antwort vom zweiten Transceiver überprüft (z. B. validiert) der erste Transceiver die Identifikationsdaten. Der erste Transceiver adressiert dann automatisch den zweiten Transceiver einzeln, indem er ein adressiertes Signal sendet, das mindestens einen Teil der verifizierten Identifikationsdaten und einen Befehl an den zweiten Transceiver über eine zweite Adresse auf dem Kommunikationsnetzwerkbus enthält.

Die Druckschrift EP 3 065 348 B1 offenbart einen Busknoten-IC, der mindestens einen statischen Adressauswahlanschluss umfasst. Der IC umfasst ferner eine Erfassungsschaltung zum Erfassen eines Zustands des statischen Adressauswahlanschlusses und eine Kommunikationsschaltung, die zum Bestimmen einer Knotenadressenkennung unter Berücksichtigung des erfassten Zustands angepasst ist. Die Erfassungsschaltung ist zum Erfassen des Zustands durch Bestimmen einer elektrischen Eigenschaft einer passiven elektronischen Komponente angepasst, wenn sie mit dem statischen Adressauswahlanschluss verbunden ist. Die Kommunikationsschaltung ist zum Empfangen/ Senden von Daten über den Datenbus gemäß einem ersten Kommunikationsprotokoll unter Verwendung der Knotenadressenkennung zur Identifizierung des IC und zum Empfangen/ Senden von Daten über den Datenbus ausgelegt ) gemäß einem zweiten Kommunikationsprotokoll unter Verwendung einer weiteren Knotenadressenkennung zur Identifizierung des IC, wobei die Kommunikationsschaltung zum Konfigurieren der weiteren Knotenadressenkennung unter Verwendung von Daten angepasst ist, die unter Verwendung des ersten Protokolls empfangen wurden.

Die Druckschrift US 2010/0250805 A1 offenbart in einem ersten Aspekt ein Kommunikationsprotokoll für die Kommunikation zwischen einer oder mehreren Entitäten, wie z. B. Geräten, Hosts oder einem anderen System, das über ein Netzwerk kommunizieren kann. Ein zweiter Aspekt betrifft eine Systemarchitektur, die es ermöglicht, mehr als ein Slave-System (z. B. ein Slave-Gerät) mit einem Master-System (z. B. einem Master-Gerät) in einem Kommunikationssystem zu verbinden, das ein Master/ Slave-Protokoll implementiert. In einem dritten Aspekt wird ein Durchgangsgerät offenbart, das die Kommunikation und Authentifizierung mit einem oder mehreren nachgeschalteten Slave-Geräten erleichtert. Ein weiterer Aspekt betrifft eine sternbasierte Konfiguration von an den Master gekoppelten Slave-Geräten sowie Protokolle zur Kommunikation und Authentifizierung von Slave-Geräten. Ein vierter Aspekt betrifft ein Protokoll, das die Kommunikation zwischen Entitäten ohne vorherige Kenntnis des Kommunikationsprotokolls ermöglicht. In einem solchen Protokoll werden beispielsweise Informationen, die eine Datenstruktur des Kommunikationsprotokolls beschreiben, zwischen kommunizierenden Einheiten übertragen. Ferner wird ein Authentifizierungsprotokoll bereitgestellt, um eine bidirektionale Authentifizierung zwischen kommunizierenden Entitäten bereitzustellen. In einem speziellen Beispiel umfassen die Entitäten ein Master-Gerät und ein Slave-Gerät, die über eine serielle Verbindung verbunden sind. In einem anderen speziellen Beispiel kann das Kommunikationsprotokoll verwendet werden, um eine unausgeglichene Übertragung zwischen kommunizierenden Einheiten durchzuführen.

In diesem Zusammenhang wird auch eine alternative Konfiguration offenbart, die es auch mehreren Slave-Geräten ermöglicht, mit einem Master zu kommunizieren. In dieser Konfiguration ist der Master-Vorrichtung mehr als eine serielle Schnittstelle vorgesehen, die mit mehr als einer entsprechenden Slave-Vorrichtung in einer Sternkonfiguration gekoppelt sein kann. In dieser Konfiguration werden Informationen, die an ein Slave-Gerät übermittelt werden, vom Master an andere Slave-Geräte wiederholt. Auf diese Weise erhält jedes Slave-Gerät die gleichen Informationen vom Master. Wenn beispielsweise eine Datenänderung von einem Slave an das Master-Gerät übertragen wird, wird diese Informationsänderung an andere Slave-Geräte wiederholt. Ferner wird ein Authentifizierungsverfahren bereitgestellt, bei dem sich jedes Slave-Gerät beim Master-Gerät authentifiziert, um Zugriff auf die im Master gespeicherten Daten zu bekommen.

Die Druckschrift WO 2015/149757 A2 offenbart ein Steckverbindermodularsystem mit zumindest einem Steckverbindermodul, das zumindest einen Sensor, z. B. einen Stromsensor, besitzt. Das Steckverbindermodularsystem umfasst eine Auswertungselektronik mit einer Steuerelektronik für ein Bussystem. Diese Auswertungselektronik kann in einem Mastermodul des Steckverbindermodularsystems angeordnet sein und ist über das Bussystem mit dem zumindest einen Sensor elektrisch leitend verbunden. Die Steckverbindermodule können zusätzliche Kontaktmittel in Form von Steck- (männlich) und Buchsenkontakten (weiblich) aufweisen, über welche sie unter einander kontaktieren. Dadurch ist eine Aneinanderreihung einer Vielzahl von Steckverbindermodulen möglich. So kann eine Datenbusleitung durch beliebig viele Steckverbindermodule, z. B. in Form einer Punkt- zu Punktverbindung, bis zum Mastermodul durchgeschliffen werden, wobei die Steckverbindermodule aus elektronischer Sicht miteinander in Reihe geschaltet sind. Dadurch kann die geometrische Position der einzelnen Steckverbindermodule im Steckverbindermodularsystem über eine sequentielle Selbstkonfiguration ihrer sogenannten IDs ("Identifikation Number"), z. B. durch sequentielles "Hochzählen", ermittelt und der Auswertelektronik mitgeteilt werden. Die Auswertelektronik kann daraufhin die Daten der Sensoren den dazugehörigen Steckverbindermodulen zuordnen.

Nachteilig bei diesem Stand der Technik ist, dass die mit den besagten Kontaktmitteln zur gegenseitigen Kommunikation versehenen Steckverbindermodule im Modularrahmen geometrisch direkt aneinander anschließen müssen, um eine unterbrechungsfreie Datenleitung zu erzeugen. Auf dem Markt existiert aber bereits eine Vielzahl herkömmlicher Steckverbindermodule, welche keine derartigen zusätzlichen Kontaktmittel besitzen. Somit ist die Anordnung der Steckverbindermodule im Modularrahmen dahingehend eingeschränkt, dass gegebenenfalls alle herkömmlichen Module hintereinander an dem vom Mastermodul entfernten Ende des Modularrahmens angeordnet sein müssen. Weiterhin müssen zur Datenübertragung diejenigen Steckverbindermodule, welche die besagten Kontaktmittel aufweisen, direkt aneinander anschließen, d. h. es darf zwischen ihnen kein Steckplatz frei bleiben oder durch ein herkömmliches Modul belegt sein.

In der Praxis hat sich gezeigt, dass dieser Mangel an Flexibilität zuweilen große Probleme verursachen kann, beispielsweise wenn eine bestimmte Reihenfolge der Steckverbindermodule durch eine bestimmte Anwendung, z. B. durch einen festgelegten Aufbau eines Gegensteckers, vorgegeben ist. Insbesondere gilt dies, wenn auch der Gegenstecker ein solches Steckverbindermodularsystem mit Slavemodulen aufweist, welche in ihrer Anordnung vergleichbaren Restriktionen unterworfen sind. Insbesondere ist die Notwendigkeit der Positionierung des Mastermoduls an einem Ende des jeweiligen Modularrahmens und der konventionellen Steckverbindermodule am anderen Ende des jeweiligen Modularrahmens in dieser Hinsicht besonders problematisch. In einem weiteren Aspekt kann eine Fehlersuche gegebenenfalls erheblich erschwert sein, da es auf diese Weise verhältnismäßig aufwendig ist, ein defektes oder nur bedingt funktionstüchtiges Slavemodul aus einer Vielzahl von Slavemodulen ausfindig zu machen.

### Aufgabenstellung

Die Aufgabe der Erfindung besteht darin, ein Steckverbindermodularsystem mit einem Datenbus anzugeben, das die vorgenannten Probleme überwindet, und bezüglich der geometrischen Anordnung seiner Module, insbesondere seiner Master- und Slavemodule, möglichst frei konfigurierbar ist.

Diese Aufgabe wird durch den Gegenstand der unabhängigen Ansprüche gelöst.

Vorteilhafte Ausgestaltungen der Erfindung sind in den Unteransprüchen angegeben.

Das erfindungsgemäße Steckverbindermodularsystem weist Folgendes auf:
a. Einen Modularrahmen für einen Rechtecksteckverbinder, wobei der Modularrahmen zwei einander gegenüberliegende lange Seitenteile besitzt;
b. ein Bussystem mit mindestens einem Datenbus, aufweisend mindestens eine sich über zumindest eine der beiden langen Seitenteile in Längsrichtung erstreckende Leiterbahn zur elektronischen Datenübertragung;
c. ein im Modularrahmen angeordnetes oder anzuordnendes Mastermodul mit mindestens einem elektrischen Buskontakt zum Senden von Anfragen und zum Empfang von Antworten über den Datenbus;
d. mehrere im Modularrahmen angeordnete oder anzuordnende Slavemodule mit jeweils mindestens einem elektrischen Buskontakt zum Empfang von Anfragen des Mastermoduls und zum Senden von Antworten an das Mastermodul;
   wobei
e. das Mastermodul und die Slavemodule mit ihrem jeweils mindestens einen Buskontakt über die mindestens eine Leiterbahn in Form einer Parallelschaltung elektrisch leitend miteinander verbunden sind.

Das erfindungsgemäße Messverfahren dient zum Messen einer Messgröße in mindestens einem Slavemodul des Steckverbindermodularsystems und zum Übertragen entsprechender Messdaten vom Slavemodul an ein Mastermodul des Steckverbindermodularsystems und weist die folgenden Schritte auf:
A.) Das Mastermodul adressiert mehrere Slavemodule gemäß der Steckposition des jeweiligen Slavemoduls in einem Modularrahmen;
B.) das Mastermodul fordert von den Slavemodulen über einen Datenbus jeweils eine Kennung an;
C.) die Slavemodule übertragen ihre jeweilige Kennung über den Datenbus an das Mastermodul;
D.) das Mastermodul erkennt die Art des jeweiligen Slavemoduls anhand dessen Kennung;
E.) das Mastermodul lädt jeweils ein zur Art des Slavemoduls passendes Softwareprogramm aus einer externen Quelle;
F.) das Mastermodul speichert die Softwareprogramme in einem kombinierten Programm/Datenspeicher ab;
G.) das Mastermodul lässt die jeweiligen Softwareprogramme über einen zum Mastermodul gehörenden Mikroprozessor ausführen, indem es einzelne Anweisungen über den Datenbus an das Slavemodul überträgt;
   ∘ G1) das Mastermodul lässt seinen Mikroprozessor zumindest ein Softwareprogramm ausführen, das zumindest ein Slavemodul zum Messen zumindest einer Messgröße und zum Vorhalten entsprechender Messdaten veranlasst;
H.) das Mastermodul fragt über den Datenbus die Messdaten vom jeweiligen Slavemodul ab;
I.) das jeweilige Slavemodul sendet die angefragten Messdaten an das Mastermodul;
J.) das Mastermodul speichert die Messdaten als dem Slavemodul zugehörig im kombinierten Programm/Datenspeicher ab.

Bei dem Mastermodul und den Slavemodulen handelt es sich üblicherweise um spezielle Steckverbindermodule, die durch ihre jeweiligen Eigenschaften, z. B. ihre oben in Punkt c. und d. beschriebenen Buskontakte, gekennzeichnet sind. In der Regel besitzen die Slavemodule entsprechende Steckverbindungskontakte, z. B. zur elektrischen Energie- und/oder Datenübertragung an einen Gegenstecker, insbesondere an korrespondierende Module eines Gegensteckers. Weiterhin können die Slavemodule bestimmte Sensoren, wie z. B. Strom-, Spannungs- und/oder Temperatursensoren besitzen, z. B. zum Kontrollieren des elektrischen Stroms durch diese Steckverbindungskontakte und/oder zum Messen deren Temperatur. Als weitere mögliche Sensoren können vorgesehen sein, sind aber nicht beschränkt auf: Vibrationssensor zur Messung von Vibrationen, z. B. im Eisenbahnbereich; Drucksensor zum Messen vom Druck, z. B. in Pneumatikmodulen, die z. B. zum Übertragen von Luftdruck vorgesehen sind; Lichtsensoren zur Überwachung von Lichtwellenleitermodulen, z. B. durch die Messung von Streulicht sowie Energiemodulen zur Messung elektrischer Energie. Es kann sich bei einigen Slavemodulen aber auch um Datenverarbeitungsmodule handeln, beispielsweise um Module, die einen Datenswitch beinhalten.

Das Mastermodul kann Mittel zur Datenverarbeitung und zur Steuerung des Datenverkehrs auf dem Datenbus besitzen und dazu insbesondere einen Datenspeicher und einen Mikroprozessor besitzen. Der Datenspeicher kann selbstverständlich auch dazu dienen, Softwareprogramme darin vorzuhalten, so dass es sich in diesem Fall genau genommen um einen kombinierten Programm-/Datenspeicher handelt. Der Übersichtlichkeit wegen wird dieser kombinierte Programm-/Datenspeicher aber auch als Datenspeicher bezeichnet, da die Programmbefehle selbstverständlich auch in Form digitaler Daten vorliegen.

Unter dem Begriff "Module" können im Folgenden diejenigen Bestandteile des Steckverbindermodularsystems aufgefasst werden, die ein Modulgehäuse aufweisen, welches sich in Form der Gehäuse der bekannten Steckverbindermodule entspricht, sich also in gleicher Form mechanisch in dem Modularrahmen oder auch in einem vergleichbaren Modularrahmen, z. B. eines Gegensteckers, einführen und befestigen lässt. Dazu können neben den bekannten Steckverbindermodulen und Master- sowie Slavemodulen also z. B. auch Energieversorgungsmodule und Breakoutmodule gezählt werden, wobei letztere dafür vorgesehen sind, im Gegenstecker angeordnet zu werden, was im Folgenden noch näher erläutert wird.

Bei dem in Punkt b. genannten Datenbus kann es sich um einen sogenannten "Master-Slave-Bus", insbesondere um einen sogenannten "I²C-Bus" (Inter-Integrated Circuit) und/oder z. B. um einen sogenannten "SM-Bus" (System Management Bus), handeln.

Unter einem "Master-Slave-Bus" ist dabei ein Datenbus zu verstehen, der, wie dem Fachmann bekannt ist, das folgende Arbeitsprinzip besitzt: Ein Teilnehmer ist der Master, alle anderen sind die Slaves. Der Master hat als einziger das Recht, unaufgefordert auf die gemeinsame Ressource, in diesem Fall den Datenbus, zuzugreifen. Der Slave kann von sich aus nicht auf die gemeinsame Ressource zugreifen; er muss warten, bis er vom Master gefragt wird oder über eine an der gemeinsamen Ressource vorbeigehenden Verbindung dem Master anzeigen, dass er gefragt werden will.

Da der in Punkt a. erwähnte Modularrahmen Bestandteil eines Rechtecksteckverbinders ist, besitzt er vorteilhafterweise eine im Querschnitt rechteckige Form mit zwei langen und zwei kurzen Seiten. Die langen Seiten gehören zu den insbesondere im Wesentlichen flächig ausgeführten, im Punkt a. erwähnten langen Seitenteilen, welche im montierten Zustand zudem im Wesentlichen in Steckrichtung ausgerichtet sein können. Handelt es sich bei dem Modularrahmen beispielsweise um einen sogenannten "Gelenkrahmen", so können die Seitenteile zur Aufnahme der Steckverbindermodule mittels eines Gelenkes auch aufgeklappt werden. Nach Einfügen der Module in den Modularrahmen werden die Seitenteile wieder zusammengeklappt, um die Module zwischen sich, insbesondere unter Verwendung von Rastmitteln, zu halten.

Zur endgültiger kraftschlüssiger Fixierung der Module im Gelenkrahmen werden die Seitenteile, z. B. durch Aufschrauben des Gelenkrahmens auf eine Fläche, z. B. in einen Innenflansch eines Steckverbindergehäuses, wieder in Steckrichtung und somit parallel zueinander ausgerichtet fixiert. Dadurch können die Steckverbindermodule zumindest kraftschlüssig und insbesondere auch zumindest bereichsweise formschlüssig und vorteilhafterweise mit besonders hoher Haltekraft zwischen den Seitenteilen im Modularrahmen fixiert werden.

In einer anderen Bauform können die Seitenteile eines Modularrahmens federnde Bereiche, z. B. elastische Wangenflächen, aufweisen, die insbesondere Laschen, bevorzugt mit Rastmitteln besitzen, wobei diese federnden Bereiche dazu geeignet sind, die Module im Modularrahmen zu fixieren. Die Steckverbindermodule können dann einfach und vorteilhafterweise auch aus Kabelanschlussrichtung und in Steckrichtung in den Modularrahmen eingeschoben und daran verrastet werden. Diese Bauform hat prinzipiell den Vorteil, dass die Module einzeln eingesteckt und entnommen werden können, ohne dass die Befestigung der anderen Module davon beeinträchtigt wird.

Die Slavemodule sind mit dem Mastermodul über den Datenbus durch eine sternpunktförmige Datenübertragungsstruktur verbunden, wobei das Mastermodul den Sternpunkt bildet.

Vorteilhafterweise kontaktieren das Master- und die Slavemodule die in Punkt b. erwähnte mindestens eine Leiterbahn des Datenbusses mit ihren jeweiligen elektrischen Buskontakten zum gegenseitigen bidirektionalen Datenaustausch elektrisch und sind somit aus elektronischer Sicht einander parallelgeschaltet. Schließlich sind die Buskontakte des jeweiligen Slavemoduls dadurch über den Datenbus elektrisch leitend und direkt mit den Buskontakten des Mastermoduls verbunden. Aus datentechnischer Sicht wird damit eine wesentliche Voraussetzung geschaffen, das Mastermodul mit den Slavemodulen sternpunktförmig zu verbinden, weil dadurch jedes Slavemodul die Möglichkeit besitzt, direkt, also ohne Umweg über andere Slavemodule, mit dem Mastermodul zu kommunizieren.

Weiterhin kann die sternpunktförmige Datenübertragungsstruktur zum einen dadurch gewährleistet sein, dass das Mastermodul selbst aktiv Daten über den Datenbus an eines der Slavemodule sendet, z. B. indem es zu einem bestimmten Zeitpunkt eine Anfrage an eines der Slavemodule schickt. Zum anderen sorgt das Mastermodul auch dafür, dass ihm zu jedem Zeitpunkt maximal nur ein einziges, in diesem Fall das angefragte Slavemodul, antwortet. Mittels eines in einem Datenspeicher des Mastermoduls gespeicherten Übertragungsprotokolls und mittels eines zum Mastermodul gehörenden Mikroprozessors setzt das Mastermodul ein entsprechendes Busprotokoll, insbesondere ein "Master-Slave-Busprotokoll", z. B. das I²C-Bus-Protokoll, um und sorgt somit dafür, dass immer nur ein Slavemodul direkt mit dem Mastermodul kommuniziert, während die anderen Slavemodule schweigen. Insbesondere antwortet jedes Slavemodul ausschließlich auf Anfragen des Mastermoduls. Weiterhin schließt das Mastermodul seine Anfragen an jedes Slavemodul datentechnisch erkennbar ab und wartet mit seiner nächsten Anfrage, bis das Slavemodul vollständig geantwortet hat. Selbstverständlich antwortet auch das jeweilige Slavemodul erst, nachdem das Mastermodul seine Anfrage erkennbar abgeschlossen hat. Dadurch ist gewährleistet, dass zu einem Zeitpunkt nie mehr als ein Teilnehmer auf dem Datenbus spricht und jedes Slavemodul ausschließlich direkt mit dem Mastermodul kommuniziert.

Durch diese zeitliche Trennung der Nachrichten auf dem Datenbus genügt zur eigentlichen Datenübertragung theoretisch eine einzige Leiterbahn, was aufgrund des geringen Platzbedarfs für diese Anwendung eine sehr vorteilhafte Variante darstellt. Andererseits hat es sich in der Praxis als äußerst vorteilhaft für die Robustheit und Flexibilität der Datenübertragung herausgestellt, wenn der Datenbus zumindest zwei Leiterbahnen besitzt, wobei die erste dieser beiden Leiterbahnen zu der besagten Datenübertragung und die zweite Leiterbahn zur Taktung ("Clock") vorgesehen ist.

Diese Form der Taktung ermöglicht es, dass beispielsweise ein Slave, der z. B. mehr Zeit für interne Prozesse, z. B. Messvorgänge, benötigt, die Taktrate mit einem sogenannten "Clock-Stretching" zwischenzeitig heruntersetzen kann, um das Mastermodul und damit den Prozessablauf zu bremsen, ohne dabei das grundsätzliche Prinzip der Master-Slave basierten Datenbusstruktur in Frage zu stellen.

Das Steckverbindermodularsystem kann außerdem zumindest zwei weitere Leiterbahnen zur Stromversorgung der Slavemodule besitzen. Dann kann beispielsweise eine erste dieser beiden weiteren Leiterbahnen dauerhaft stromführend, z. B. gleichstromführend, sein und kann so zur elektrischen Energieversorgung der Slavemodule und/oder des Mastermoduls dienen. Die Versorgungsspannung dieser Energieversorgung kann z. B. zwischen 1V und 6V, bevorzugt zwischen 2V und 4,5V liegen und insbesondere 3,3V betragen.

Bei der zweiten weiteren Leiterbahn kann es sich um eine Masseleitung zur Masseanbindung der Slavemodule und/oder des Mastermoduls handeln, so dass die Stromversorgung dadurch ein dazugehöriges Massepotential besitzt. Dieses Massepotential kann auch als Bezugspotential für andere elektronische Schaltungen genutzt werden und so z. B. auch als Bezugspotential für die elektrische Datenübertragung dienen.

Weiterhin kann zumindest eine zusätzliche Leiterbahn, z. B. gemäß des MS-Bus-Standards, als sogenannte "Interruptleitung" vorgesehen sein, z. B. um es zu ermöglichen, dass jedes Slavemodul das Mastermodul schnellstmöglich aktiv auf das Vorhandensein eines Fehlerzustands, beispielsweise auf das Auftreten einer kurzfristigen Überspannung und/oder eines kurzfristig sehr hohen Stromes und/oder einer besonders hohen Temperatur, etc. an zumindest einem seiner Steckverbindungskontakte, hinweisen kann. Der Fehlerzustand kann dem Mastermodul so insbesondere mittels einer sogenannten Alarm ("Alert")-Funktion mitgeteilt werden, bei welcher irgendein elektrisches Signal, z. B. ein elektrischer Puls, auf dem Interrupt-Bus ausreicht, um einen Interrupt des Masters auszulösen. Dabei ist es unerheblich, welches Slavemodul diesen Puls sendet, und ob möglicherweise mehrere Slave-Module diesen Puls gleichzeitig oder zumindest nahezu gleichzeitig senden. Das zu diesem Zeitpunkt vom Mastermodul gerade ausgeführte Softwareprogramm wird dann schnellstmöglich an derjenigen Stelle unterbrochen, an der es sich gerade befindet, und springt aufgrund des Interrupt-Alarms sofort in eine dafür vorgesehene, sogenannte "Interrupt-Service-Routine". Diese ist im vorliegenden Fall so ausgeführt, dass sie das Mastermodul dazu veranlasst, über die Datenleitung aus jedem der Slavemodule jeweils ein dazugehöriges sogenanntes "Interruptserviceregister" auszulesen, um zu erfahren, von welchem Slavemodul der Interrupt-Alarm ausgelöst wurde und was diesen Interrupt ausgelöst hat (z. B. Überspannung am Kontakt des betreffenden SlaveModuls). Das Interruptserviceregister wurde zuvor beim Auslösen des Interrupts, z. B. vom Sensor des Moduls, mit entsprechenden Informationen über die Ursache des Interrupts versorgt. Die Identifikation des Moduls dagegen kann sich insbesondere aus der Position des Moduls im Modularrahmen ergeben und vom Mastermodul über eine elektronische Adressierung zugeordnet werden, wie es im Folgenden beispielhaft geschildert wird.

Zur Identifizierung der geometrischen Position des jeweiligen Slavemoduls im Modularrahmen kann ein weiterer Kontaktbereich, insbesondere ein weiteres Kontaktpad, das im Folgenden gemäß seiner Funktion als Widerstands-Kontaktpad bezeichnet wird, im Bussystem vorgesehen sein. Dazu ist an jedem Modulsteckplatz je ein elektrischer Widerstand angeordnet und zwischen dem Widerstands-Kontaktpad und der Massepotential führenden weiteren Leiterbahn geschaltet. Insbesondere kann dazu der elektrische Widerstand, z. B. ein handelsüblicher Kohle- oder Metallschichtwiderstand, mit seinem ersten Anschluss elektrisch leitend mit dem Widerstands-Kontaktpad und mit seinem zweiten Anschluss mit der Masseleitung verbunden, z. B. verlötet, sein. Die Beträge der elektrischen Widerstände der unterschiedlichen Modulsteckplätze unterscheiden sich signifikant voneinander, um dadurch eine elektronische Identifikation der Einsteckposition des jeweiligen Slavemoduls zu ermöglichen. Insbesondere handelt es sich bei den elektrischen Widerständen unter Laborbedingungen um ohmsche Widerstände, die sich durch ihren Betrag messbar voneinander unterscheiden.

Der Betrag des jeweiligen elektrischen Widerstands ist somit positionsabhängig gewählt. Dies dient dazu, diese Position im Modularrahmen elektronisch lesbar zu kennzeichnen. Jedes Slavemodul kann so an den jeweiligen Kontaktbereich, insbesondere an das jeweilige Kontaktpad, eine vorgegebene elektrische Spannung anlegen und einen entsprechenden Strom messen und z. B. dessen Betrag auf eine entsprechende Anfrage hin an das Mastermodul übertragen, so dass das Mastermodul die Position des jeweiligen Slavemoduls über den Betrag des Stroms, d. h. indirekt des jeweiligen ohmschen Widerstands, ermitteln kann. Beispielsweise kann der erste Modulsteckplatz einen ohmschen Widerstand von R1 = 100Ω besitzen, der zweite Modulsteckplatz einen ohmschen Widerstand von R2 = 200Ω der dritte einen ohmschen Widerstand von R₃= 400Ω, etc.

Beim Anlegen einer vorgegebenen elektrischen Spannung von beispielsweise 1V würde am ersten Modulsteckplatz von einem ersten Slavemodul ein erster Strom von I₁ = 0,01 A gemessen. Dieser Wert kann vom ersten Slavemodul digitalisiert und vom Mastermodul abgefragt werden. Daraufhin kann das Mastermodul, z. B. mittels einer im Datenspeicher des Mastermoduls abgelegten Tabelle, diesem Slavemodul aufgrund des Stroms, d. h. aufgrund des elektrischen Widerstandes und somit aufgrund seiner geometrischen Position, eine bestimmte Identifikationsnummer (ID), z. B. in diesem Fall die ID 1, zuordnen, welche dem ersten Modulsteckplatz entspricht.

Ein weiteres Slavemodul kann sich dann beispielsweise in dem zweiten Modulsteckplatz befinden. Dieses weitere Slavemodul würde dann einen zweiten Strom von I₂ = 0,005A messen, diesen Wert auf Anfrage an das Mastermodul übertragen und auf die gleiche Weise die ID 2 erhalten.

Alternativ dazu könnte der zweite Modulsteckplatz aber auch frei bleiben, also zunächst von keinem Slavemodul belegt sein. Das weitere Slavemodul könnte stattdessen in irgendeinen anderen Modulsteckplatz, z. B. in den dritten Modulsteckplatz des Modularrahmens eingefügt werden. In diesem Fall würde es in gleicher Weise die zum dritten Modulsteckplatz gehörende Identifikationsnummer, beispielsweise die ID 3, erhalten.

Vergleichbares gilt dann selbstverständlich auch für die weiteren Slavemodule, d. h. sie messen den Wert des elektrischen Widerstandes, d. h. des elektrischen Stromes bei bekannter anliegender Spannung, an ihrem jeweiligen Modulsteckplatz und übertragen einen dafür signifikanten Wert an das Mastermodul. Das Mastermodul ordnet mit seiner im Datenspeicher abgelegten Tabelle dem jeweiligen elektrischen Widerstand die Nummer des Modulsteckplatzes zu, die gleichzeitig als Grundlage der ID des jeweiligen Slavemoduls dient.

Dies ist von besonderem Vorteil, weil die Slavemodule auf diese Weise nahezu beliebig im Modularrahmen verteilt werden können. Sie müssen also geometrisch nicht direkt aneinander anschließen. Es können somit beispielsweise ein- oder mehrere Modulsteckplätze zwischen den Slavemodulen zumindest zwischenzeitig frei bleiben oder es können auch herkömmliche (d. h. konventionelle) Module, die sich u. a. dadurch auszeichnen, dass sie keine Buskontakte besitzen, zwischen den Slavemodulen angeordnet sein. Dennoch kann die besagte Adressierung automatisch in Abhängigkeit von der geometrischen Position der jeweiligen Module vorgenommen werden und somit Aufschluss über die geometrische Position des jeweiligen Slavemoduls geben.

Dies ist von besonderem Vorteil, wenn sowohl in einem Steckverbinder als auch in seinem Gegenstecker jeweils ein entsprechendes Steckverbindermodularsystem existiert. Schließlich stehen sich in der Praxis meist Slavemodule und herkömmliche (konventionelle) Module des Steckverbinders und des Gegensteckers gegenseitig gegenüber und werden miteinander gesteckt. Dadurch ist es in der Praxis kaum möglich, in jedem Modularrahmen die herkömmlichen (konventionellen) Module an einem Ende und das Mastermodul anderen Ende und die Slavemodule dazwischen und direkt aneinander und an das Mastermodul angrenzend anzuordnen, wie es den Restriktionen des Standes der Technik entspräche.

Vorteilhafterweise können dadurch weiterhin auch aus einem bereits bestückten Steckverbindermodularsystem nachträglich Module herausgenommen und/oder ergänzt werden, ohne dass die Konfiguration der im Modularrahmen verbleibenden Modulen sich ändert. Die ursprüngliche Verteilung der IDs bleibt für sie erhalten und ist weiterhin reproduzierbar, würde also z. B. bei einer Neuverteilung, falls dies aus softwaretechnischen Gründen einmal notwendig wird, automatisch wieder mit der ursprünglichen Verteilung übereinstimmen, solange jedes dieser Module am gleichen Modulsteckplatz verbleibt.

In einer vorteilhaften Ausgestaltung besitzt das Mastermodul eine Auswertelektronik mit einer Steuerelektronik zur Regelung der Datenübertragung auf dem Datenbus, um damit die im Steckverbindermodularsystem aufgenommenen Steckverbindermodule zu erkennen, ihre Identifikationsnummer ihrer jeweiligen geometrischen Position im Modularrahmen zuzuordnen und weiterhin Messwerte von in den Steckverbindermodulen angeordneten Sensoren dem jeweiligen Steckverbindermodul zuzuordnen und entsprechend zu verarbeiten.

Die direkte und einfache datentechnische Abbildung der Modulsteckplätze durch die jeweiligen Identifikationsnummern (IDs) hat dabei auch besondere Vorteile für die Netzwerkfähigkeit des Steckverbindermodularsystems.

Insbesondere besitzt das Mastermodul dazu eine externe Netzwerkschnittstelle, um damit zumindest einige der Messwerte und/oder daraus berechnete Größen in Form von Messdaten an ein externes Netzwerk weiterzugeben.

Weiterhin kann im Datenspeicher des Mastermoduls aber auch eine jeweilige individuelle Software der Slavemodule abgelegt sein. Mit dieser Software können beispielsweise Messvorgänge und/oder ein Kommunikationsverhalten der Slavemodule gesteuert werden. Die Software kann aber alternativ oder ergänzend auch die Netzwerkfähigkeit der Slavemodule gegenüber dem externen Netzwerk betreffen, wie im Folgenden näher erläutert wird.

Die individuelle Software der Slavemodule, die insbesondere zumindest teilweise in Form von sogenannten "Softwarecontainern" vorliegt, kann, z. B. über die Netzwerkschnittstelle des Mastermoduls, in den Datenspeicher geladen werden, sobald das entsprechende Slavemodul in den Modularrahmen eingefügt und vom Mastermodul erkannt wird. Dazu ist es vorteilhaft, wenn die Module eine Kennung besitzen, aus der hervorgeht, welcher Art das jeweilige Slavemodul ist und welche Software das Mastermodul laden soll. Beispielsweise kann es sich bei dem Slavemodul um ein Strom-, Spannungs- oder Temperaturmessmodul handeln, zu denen jeweils eine andere Software gehört. Es kann sich aber auch um ein datentechnisches Modul handeln, dass z. B. einen sogenannten Datenswitch beinhaltet, so dass die Software dieser Art von Modul erheblich von der Art eines Strommessmoduls, der Art eines Spannungsmessmoduls oder der Art eines Temperaturmessmoduls abweicht.

Diese Kennung kann das Mastermodul von den jeweiligen Slavemodulen abfragen und in seinem Datenspeicher, z. B. in seiner besagten Tabelle zusammen mit der jeweiligen ID als zum jeweiligen Modul zugehörig speichern. Weiterhin kann diese individuelle Software auch aus dem Datenspeicher des Mastermoduls gelöscht werden, sobald das entsprechende Slavemodul aus dem Modularrahmen entfernt wird. Dieses Prinzip gestattet beliebig viele Umkonfigurationen des Steckverbindermodularsystems, d. h. es können beliebig viele Slavemodule dem Steckverbindermodularsystem entnommen und hinzugefügt werden, ohne dass der Speicherbedarf des Datenspeichers dadurch steigt und/oder eine angemessen dimensionierte Speicherkapazität des Datenspeichers dadurch jemals überschritten wird, da die nicht benötigte Software automatisch gelöscht und die benötigte Software automatisch nachgeladen wird.

In einer bevorzugten Ausgestaltung kann die Software zweier gleichartiger Module zur Speicherplatzeinsparung nur einmal im Datenspeicher abgelegt sein. Die individuellen Daten jedes Moduls müssen dann selbstverständlich trotzdem gesondert gespeichert werden.

Das Mastermodul kann jedem Slavemodul zu dessen Netzwerkfähigkeit im externen Netzwerk zusätzlich zu der besagten dazugehörigen ID eine weitere virtuelle Identifikationsnummer für das externe Netzwerk zuweisen, das Slavemodul also zusätzlich vom externen Netzwerk adressieren lassen. Diese virtuelle ID kann das Mastermodul in der besagten Tabelle der ID des Moduls zuordnen und/oder zusammen mit der individuellen Software jedes Moduls in seinem Datenspeicher ablegen. Aus Sicht des Netzwerks ist das jeweilige Slavemodul dann scheinbar direkt, aber tatsächlich in Form eines virtuellen Netzwerkteilnehmers, adressierbar und ansprechbar, d. h. das externe Netzwerk kommuniziert scheinbar direkt mit dem virtuellen Slavemodul, nämlich mit der Software des jeweiligen Slavemoduls, über dessen virtuelle ID. Auf diese Weise kann das externe Netzwerk direkt Daten, z. B. Messdaten, mit dem Slavemodul austauschen und/oder Prozesse, z. B. Messprozesse des Slavemoduls steuern, auch wenn dieser Datenaustausch, physikalisch betrachtet, zunächst nur zwischen dem externen Netzwerk und dem Mastermodul stattfindet. Mit anderen Worten kann das Mastermodul die von ihm verwalteten Slavemodule dem externen Netzwerk gegenüber abbilden, so dass das Netzwerk ohne Änderungen oder zusätzliche Informationen auf die Slavemodule zugreifen kann.

Vorteilhafterweise ist ein solches Prinzip durch die besonders klare Struktur der Vergabe der IDs und ihrer geometrischen Zuordnung zu den Modulsteckplätzen um Modularrahmen besonders einfach handhabbar. Insbesondere ist die Tatsache, dass bezüglich im Modularrahmen verbleibender Slavemodule auch bei Entnahme anderer Slavemodule keine Umstrukturierungen stattfinden, sowohl für die Übersichtlichkeit der Programmierung als auch die Betriebssicherheit des Steckverbindermodularsystems sowie für die händische Bedienbarkeit von großem Vorteil. Das Verhältnis zwischen Herstellungskosten und Qualität des Steckverbindermodularsystems kann dadurch erheblich verbessert werden.

In einer vorteilhaften Ausgestaltung kann das Steckverbindermodularsystem ein Bussystem mit insgesamt fünf durchgehende Leiterbahnen besitzen, nämlich die beiden besagten Leiterbahnen für den Datenbus (Daten, Clock), die beiden weiteren Leiterbahnen für die Stromversorgung (Versorgungsspannung, Massepotential) sowie die besagte zusätzliche Leiterbahn als Interruptleitung.

In anderen Ausgestaltungen kann aber, abhängig von der jeweiligen Anwendung oder von bestimmten elektronischen Konzepten, eine andere Zahl von Leiterbahnen zur Umsetzung des beschriebenen Buskonzepts vorgesehen sein. Zum einen ist die Zahl der durchgehenden Leiterbahnen den jeweiligen Stromversorgungs- und Masseführungskonzepten geschuldet, zum anderen den jeweiligen Datenbuskonzepten. Unter dem Begriff "durchgehende Leiterbahnen" sind Leiterbahnen zu verstehen, welche in der Lage sind, die im Modularrahmen angeordneten Slavemodule elektrisch leitend mit dem Mastermodul zu verbinden, d. h. das Mastermodul und jedes in dem Modularrahmen aufgenommene Slavemodul kontaktiert die durchgehende Leiterbahn elektrisch mit seinen Buskontakten.

Die Leiterbahnen des Bussystems sind erfindungsgemäß in mindestens eine Leiterkarte integriert. Bevorzugt kann die Leiterkarte formschlüssig in einer Ausnehmung des Seitenteils des Modularrahmens angeordnet und insbesondere durch Verkleben daran befestigt sein. Die Leiterkarte ist in oder an einer der beiden langen Seitenteile des Modularrahmens so angebracht, dass ihre Vorderseite in das Innere des Modularrahmens weist. Ergänzend können sämtliche oder einige der Leiterbahnen auch in der sogenannten "MID"(Moulded Interconnection Device)-Technik in den Modularrahmen integriert werden, insbesondere wenn es sich bei dem Modularrahmen um einen Kunststoffhalterahmen handelt. Die Leiterbahnen weisen an der nach innen gerichteten Vorderseite zur Kontaktierung jedes Buskontaktes sowohl jedes Slavemoduls als auch des Mastermoduls jeweils zumindest eine Kontaktierungsfläche und/oder zumindest einen Kontaktierungsbereich auf.

Die Leiterbahnen erstrecken sich vorteilhafterweise in Längsrichtung im Wesentlichen über das gesamte Seitenteil. Es können beispielsweise einige der Leiterbahnen auf der Vorderseite der Leiterkarte und andere auf der Rückseite der Leiterkarte verlaufen. Bei einer mehrschichtigen Leiterkarte können auch Leiterbahnen im Inneren der Leiterkarte verlaufen. Weiterhin können einige oder sämtliche der Leiterbahnen Abschnittsweise auf der Vorderseite der Leiterkarte und/oder abschnittsweise auf der Rückseite der Leiterkarte und/oder Abschnittsweise im Inneren einer mehrschichtigen Leiterkarte verlaufen. Beispielsweise kann eine Leiterbahn auf der Vorderseite unterbrochen, jedoch in diesem Bereich durch ein Leiterbahnsegment der Rückseite gebrückt sein, d. h. die auf der Vorderseite angeordneten Leiterbahnteile werden durch ihre rückseitige Brücke elektrisch leitend miteinander verbunden, so dass die gesamte Leiterbahn als durchgehend angesehen werden kann. Alternativ oder ergänzend können mehrere, beispielsweise zwei Kontaktpads auf der Vorderseite durch eine kurze Leiterbahn auf der Rückseite in Form einer Brücke mit einander verbunden sein. Auf diese Weise können für jedes Slavemodul ein- oder mehrere Kontaktbereiche, insbesondere Kontaktpads, in Längsrichtung nebeneinander auf der Leiterkarte angeordnet sein. Dadurch können jedem Slavemodul mehrere zueinander in Längsrichtung versetzte Kontaktbereiche, insbesondere Kontaktpads, zur Verfügung gestellt werden, was die Konstruktion der Module, insbesondere die Anordnung der Buskontakte am Modulgehäuse, erheblich erleichtert. Insbesondere können auf diese Weise mehrere Kontaktpads für dieselbe Funktion geometrisch besonders geeignet zur flexiblen Kontaktierung durch unterschiedlich und/oder unterschiedlich orientierten Modulen zur Verfügung gestellt werden, insbesondere indem sie auf der Rückseite der Leiterkarte gebrückt, d. h. durch eine vergleichsweise kurze Leiterbahn elektrisch leitend miteinander verbunden, sind.

In den meisten Fällen ist es ausreichend, Master- und Slavemodule in gleicher Orientierung in ihren jeweiligen Halterahen einzufügen. Werden auf diese Weise zwei Modularrahmen bestückt, so kann einer davon für einen Stecker und der andere für den dazugehörigen Gegenstecker verwendet werden.

Beim bestimmungsgemäßen Zusammenstecken von Stecker und Gegenstecker sind dann normalerweise die Steckgesichter der Slave- und der Steckverbindermodule automatisch zueinander ausgerichtet und können so miteinander gesteckt werden, sofern ihre Steckgesichter zueinander passen, z. B. indem sie z. B. männlich und weiblich ausgebildet sind und die gleiche Steckverbindernorm erfüllen, und weiterhin ggf. passend zueinander kodiert sind, etc. Unter dem Begriff "Module" können, wie bereits erwähnt, u. a. Master- und/oder Slavemodule aber auch z. B. im Folgenden beschriebene Energie- und Breakoutmodule verstanden werden, die diesbezüglich einige Besonderheiten aufweisen.

Für bestimmte Anwendungen kann es nämlich besonders vorteilhaft sein, wenn die Module des Steckverbinders und die Module des Gegensteckers im gesteckten Zustand von Stecker und Gegenstecker in die gleiche Richtung weisen. Dazu müssen zumindest einige Module in einem der beiden Modularrahmen umgekehrt orientiert angeordnet werden.

Eine solche umgekehrte Orientierung zweier zusammen zu steckender Module kann z. B. zwischen dem Mastermodul des Steckverbinders und dem Energieversorgungsmodul des Gegensteckers sinnvoll sein. Ein solches Energieversorgungsmodul dient z. B. zur Zwischenspeicherung elektrischer Energie, z. B. zur zeitlichen Überbrückung eines Zeitraums, in dem das Steckverbindermodularsystem keine kabelgebundene Energieversorgung besitzt.

Eine weitere Anwendung umgekehrter Orientierung zweier zusammen zu steckender Module kann das Mastermodul des Steckverbinders und ein Breakoutmodul des Gegensteckers betreffen. Eine typische Anwendung einer solchen Kombination von Master- und Breakoutmodul besteht darin, dass sowohl der Steckverbinder als auch der Gegenstecker ein Steckverbindermodularsystem aufweisen. Selbstverständlich könnte dann jedes dieser beiden Steckverbindermodularsysteme ein eigenes Mastermodul besitzen. Dies ist jedoch vergleichsweise höchst unwirtschaftlich. Eine bevorzugte Ausgestaltung sieht daher vor, dass nur der Steckverbinder das Mastermodul besitzt. Im Gegenstecker ist dagegen das mit dem Mastermodul steckbare Breakoutmodul vorgesehen, das dazu geeignet ist, mit dem Mastermodul des Steckverbinders zusammenzuwirken und mit ihm zusammen betrachtet ein gemeinsames Mastermodul für beide Steckverbindermodularsysteme zu bilden, und diese so zu einem gemeinsamen Steckverbindermodularsystem zusammenzufassen. Dazu können das Master- und das Breakoutmodul an miteinander korrespondierenden Steckplätzen der jeweiligen Halterahmen des Steckverbinders und des Gegensteckers angeordnet werden, so dass sie beim Stecken von Steckverbinder und Gegenstecker mit einander, insbesondere über eine gemeinsame USB-Schnittstelle, datentechnisch verbindbar sind.

Weiterhin besitzt das Breakoutmodul Buskontakte zur elektrischen Kontaktierung des Bussystems des Gegensteckers. In einer bevorzugten Ausgestaltung kann das Breakoutmodul die empfangenen Daten aufbereiten und über eine gemeinsame Schnittstelle an das Mastermodul übertragen. Das Mastermodul kann diese Signale dann in Form eines weiteren Datenbusses insbesondere mittels seinem Mikroprozessors empfangen und mit dem Mikroprozessor und einem im Datenspeicher abgelegten weiteren Busprotokoll verarbeiten. Dabei können die Identifikationsnummern der Module des Gegensteckers entsprechend gekennzeichnet und/oder geändert werden, um diese Module erkennbar von den Modulen des Steckverbinders insbesondere einzeln zu unterscheiden und/oder als Gruppe als zum Gegenstecker gehörig zu kennzeichnen. Alternativ dazu kann das Breakoutmodul die Leitungen des Bussystems des Gegensteckers auch einfach an das Mastermodul übertragen. Das Mastermodul kann diese dann mit dem Bussystem des Steckverbinders elektrisch leitend verbinden, so dass das Bussystem des Steckverbinders einfach durch das Bussystem des Gegensteckers erweitert wird. Das Mastermodul arbeitet wie oben beschrieben und hat so lediglich eine größere Anzahl an Slavemodulen, nämlich zusätzlich die Slavemodule des Gegensteckers, zu verwalten. Dazu können die Slavemodule entweder geeignet in den Halterahmen angeordnet sein - in einem vorteilhaften Konzept wird jedes Slavemodul mit einem herkömmlichen Modul gesteckt - und/oder die Widerstände sind an den jeweiligen Halterahmen geeignet angeordnet und/oder gewählt und/oder das Breakoutmodul modifiziert die entsprechend Information, betreffend die jeweilige Identifikationsnummer und insbesondere die geometrische Anordnung der Module. Vorteilhafterweise kann das Mastermodul dadurch die Module des Gegensteckers von denen des Steckverbinders einzeln und bevorzugt auch als Gruppe unterscheiden.

Wie beim bereits beschriebenen Einfügen eines neuen Slavemoduls kann das Mastermodul somit beim Zusammenstecken mit dem Breakoutmodul die Slavemodule des Gegensteckers erkennen und die jeweils dazu gehörige Software, soweit nötig, z. B. über das externe Netzwerk, anfordern und in seinem Datenspeicher ablegen. Auf diese Weise kann das Mastermodul zusätzlich zu den Slavemodulen des Steckverbinders aus die Slavemodule des Gegensteckers verwalten.

Bei der Verwendung des Breakoutmoduls lassen sich die Vorteile der erfindungsgemäßen freien Konfigurierbarkeit besonders deutlich erkennen. Im Stand der Technik müssten nämlich sowohl im Steckverbinder als auch im Gegenstecker sämtliche Slavemodule im Bereich des Master- und des Breakoutmoduls angeordnet sein, was für die meisten Anwendungen technisch keinen erkennbaren Nutzen hat. Schließlich macht es in der Regel wenig Sinn, zwei Strommessmodule aneinander anzuschließen. Dagegen besteht eine übliche Anwendung darin, ein Strommessmodul an ein herkömmliches (konventionelles) Modul anzuschließen. Dazu muss sich dieses herkömmliche Modul aber auch an dem entsprechenden Modulsteckplatz im Modularrahmen befinden, was im Stand der Technik aus den oben genannten Gründen zumindest problematisch wäre, erfindungsgemäß aber in der besagt frei konfigurierbaren Form ohne weiteres geschehen kann.

Aus Gründen der Einheitlichkeit und der Herstellungskosten ist es besonders vorteilhaft, für möglichst viele Module, insbesondere für das Master- und das Breakoutmodul aber auch für das Energiemodul und/oder für die Slavemodule, im Wesentlichen die gleiche Gehäusebauform zu verwenden. Der Begriff "im Wesentlichen" bedeutet dabei, dass z. B. die Buskontakte bei einigen Bauformen derart ausgeführt sind, so dass die Module bezüglich ihrer Steckrichtung in umgekehrter Orientierung in dem Modularrahmen angeordnet sein können und in dieser umgekehrten Orientierung dazu in der Lage sind, dessen Bussystem elektrisch zu kontaktieren.

Insbesondere besitzt jedes Modulgehäuse zwei Rastnasen, die an zwei einander gegenüberliegenden Stirnflächen der im wesentlichen quaderförmigen Modulgehäuses angeordnet sind. Damit können die Module in entsprechende Rastfenster der Seitenteile des Modularrahmens einrasten. Insbesondere unterscheiden sich die beiden bevorzugt im Querschnitt rechteckigen Rastnasen voneinander durch ihre Form, insbesondere durch ihre Größe, z. B. ihrer jeweiligen Länge. Durch diese beiden unterschiedlichen Rastnasen und die dazugehörigen Rastfenster der beiden einander gegenüberliegenden Seitenteile ist die Orientierung der Module im Modularrahmen bezüglich einer Rotation um ihre jeweilige Längsachse vorgegeben.

Wie zuvor beschrieben, ist es jedoch vorteilhaft, einige Module, z. B. Energie- und Breakoutmodule, bezüglich der Steckrichtung in umgekehrter Orientierung in ihren jeweiligen Modularrahmen, in diesem Fall in den Modularrahmen des Gegensteckers, einzufügen. Diese Module werden im Folgenden als umgekehrt orientierte Module bezeichnet. Sie unterscheiden sich von den anderen Modulen im Wesentlichen durch die Position ihrer Buskontakte am sonst gleichen Modulgehäuse, um in umgekehrter Orientierung mit dem Bussystem kontaktieren zu können.

Zur Vereinfachung der Formulierungen sei im Folgenden die Kabelanschlussseite eines Steckverbindermoduls, des entsprechenden Modulgehäuses sowie des Modularrahmens als oben und die gegenüberliegende jeweilige Steckseite als unten angesehen.

Dann ist das Bussystem an den Seitenteilen des Modularrahmens vorteilhafterweise unterhalb (steckseitig) der Rastfenster angeordnet.

Dementsprechend befinden sich die Buskontakte an den darin angeordneten Modulgehäusen ebenfalls unterhalb deren Rastnasen. Bei den umgekehrt orientierten Modulen dagegen müssen sich die Buskontakte oberhalb der Rastnasen befinden, um im eingebauten Zustand mit dem Bussystem des Halterahmens des Gegensteckers kontaktieren zu können.

Gemäß den vorangegangenen Betrachtungen zum Bussystem kann jedes Slavemodul insbesondere sechs Buskontakte aufweisen, nämlich zwei für die beiden Datenleitungen, zwei für die Stromversorgung, eine für die Interruptleitung sowie eine weitere zur Kontaktierung des Widerstands-Pads. Diese Buskontakte des Slavemoduls korrespondieren mit ihrer internen Elektronik, die für die verschiedenen Slavemodule sowie auch für die umgekehrt orientierten Module weitgehend gleich ist und aus Kostengründen möglichst gemeinsam, serienmäßig auf Schaltungsträgerbauteilen, die z. B. in Form von Leiterkarten ausgeführt sind, vorgefertigt wird.

Damit bei der Herstellung der umgekehrt orientierten Modulen auch wesentliche Grundelemente der Elektronik, insbesondere die Schaltungsträger, in möglichst ähnlicher Form übernommen werden können, hat es sich in der Praxis als besonders vorteilhaft herausgestellt, wenn die Buskontakte in horizontaler Richtung möglichst auf der gleichen Seite des Modulgehäuses angeordnet werden können. Folglich müssten die Positionen der Kontaktpads des Bussystems für die umgekehrt orientierten Module in horizontaler Richtung versetzt angeordnet sein. Dem entgegen steht das Bedürfnis, sämtliche Module flexibel an jeder gewünschten Stelle im Modularrahmen anordnen zu können und denselben Modularrahmen für den Steckverbinder und den Gegenstecker verwenden zu können.

Um stets dieselbe Anordnung von Leiterbahnen und Kontaktpads an dem Modularrahmen und insbesondere auf der Leiterkarte verwenden zu können, ist es daher besonders vorteilhaft, im Bussystem mehrere Kontaktpads für die gleiche Funktion vorzusehen. Beispielsweise können pro Modulsteckplatz zwei Kontaktpads existieren, welche eine Verbindung mit der Masseleitung herstellen. Genau so können gegebenenfalls an jedem Modulsteckplatz mehrere, z. B. zwei Widerstands-Kontaktpads angeordnet sein, von denen je nach Orientierung wahlweise nur eins vom entsprechenden Buskontakt des jeweiligen Moduls kontaktiert wird. Diese beiden Widerstands-Kontaktpads können beispielsweise auf der Rückseite oder in einer inneren Schicht der Leiterkarte gebrückt, d. h. elektrisch leitend miteinander verbunden, und gemeinsam über den entsprechenden elektrischen Widerstand an die Masseleitung angeschlossen sein. Auf diese Weise kann in einer besonders vorteilhaften Ausgestaltung ein einziger Modularrahmen zur Kontaktierung von Modulen beider Orientierungen geeignet sein.

In einer weiteren möglichen Ausgestaltung kann an den beiden Längsseiten eines Modularrahmens jeweils ein komplettes oder ein partielles Bussystem vorgesehen sein und das jeweilige Modul kann ebenfalls an zwei einander gegenüberliegenden Stirnseiten entsprechende Buskontakte aufweisen. Dann kann z. B. wahlweise das eine oder das andere Bussystem oder es können auch beide Bussysteme verwendet werden. Diese Lösung ist zwar besonders komfortabel, allerdings vergleichsweise teuer und daher als eher unwirtschaftlich anzusehen.

Zusammenfassend und/oder ergänzend besitzt das erfindungsgemäße Steckverbindermodularsystem gegenüber dem Stand der Technik folgende Vorteile:

Die physikalische Position der Module, insbesondere der Slavemodule, korrespondiert mit ihrer ID. Dadurch können fehlerhafte Module leicht lokalisiert und so z. B. auch automatisch ausgetauscht werden, z. B. durch einen Roboter. Durch die oben beschriebene Möglichkeit zur automatischen Selbstkonfiguration der IDs und der Software des Steckverbindermodularsystems wird eine automatische Bestückung des Modularrahmens mit Modulen, z. B. Slavemodulen, und/oder eine automatische Reparatur defekter und/oder Anpassung an geänderte Anforderungen ermöglicht. Die Fehlersuche nach defekten oder nur bedingt funktionstüchtigen Modulen wird durch die sternpunkförmige Busstruktur erheblich vereinfacht. Zudem wird die Suche nach der Fehlerursache insbesondere durch die virtuelle Netzwerkfähigkeit der Slavemodule erleichtert.

Weiterhin können durch die Erfindung Fehler, insbesondere Übertragungs- und/oder elektronische Kontaktierungsfehler des Datenbussystems aus den folgenden Gründen reduziert oder gar vermieden werden: Im Modularrahmen angeordnete Module, d. h. Steckverbindermodule, Slavemodule, Mastermodule etc., haben in der Regel ein gewisses sogenanntes "Spiel", d. h. sie sind häufig mit einer bestimmten mechanischen Toleranz im Modularrahmen gehalten. Dies wird üblicherweise auch als erwünscht angesehen, da es zumindest bei den Steckverbindermodulen dazu dient, beim Steckvorgang entsprechende Toleranzen gegenüber dem Gegenstecker auszugleichen. In Bezug auf die Kontaktierung der Master- und Slavemodule mit dem gemeinsamen Datenbussystem sind diese Toleranzen jedoch problematisch. Im einem System, wie es dem Stand der Technik entspricht, ergibt sich daraus schließlich eine Vielzahl von in Reihe geschalteten möglichen Kontaktierungsfehlern, von denen jeder die aus Mastermodulsicht hinter ihm liegenden Slavemodule vom Datenbus trennt.

Demgegenüber besitzt die erfindungsgemäße Lösung zwei wesentliche Vorteile: Zum einen ist aufgrund der erfindungsgemäßen Parallelschaltung der Master- und Slavemodule lediglich dasjenige Slavemodul von einem möglichen Kontaktierungsfehler betroffen, bei dem dieser Fehler auftritt. Zum anderen treten derartige Fehler erfindungsgemäß nicht, oder nur noch äußerst selten, auf, da die Anschlusspads eine ausreichende Größe aufweisen, um derartige mechanische Toleranzen auszugleichen. Die Anschlusspads können Bestandteil der Leiterkarte oder der besagten MID-Beschichtung eines Kunststoffrahmens sein und sind, wie bereist beschrieben, mit den elektrischen Leiterbahnen das Datenbussystems elektrisch leitend verbunden. Im Betrieb werden sie von den Buskontakten der im Modularrahmen angeordneten Master- und/oder Slavemodule direkt kontaktiert. Innerhalb eines vorgegebenen Bereichs, der durch die Größe der Anschlusspads vorgegeben ist, können sich diese Module daher im Modularrahmen bewegen, wobei ihre Buskontakte gleichzeitig den elektrischen Kontakt mit den Anschlusspads aufrechterhalten.

Ein weiterer Vorteil besteht darin, dass das erfindungsgemäße Bussystem abwärtskompatibel ist, d. h. es können auch herkömmliche Steckverbindermodule an beliebiger Steckposition im Modularrahmen verwendet werden, ohne den Datenverkehr zu unterbrechen. Somit kann das Steckverbindermodularsystem an jeden beliebigen und/oder beliebig bestückten Gegenstecker frei angepasst werden. Insbesondere kann sowohl der Steckverbinder als auch sein Gegenstecker ein Steckverbindermodularsystem mit Slavemodulen besitzen, ohne dass sich daraus Probleme bei deren Anordnung im jeweiligen Modularrahmen ergeben.

Dafür vorgesehene Module können auch in umgekehrter Orientierung in den Modularrahmen eingefügt und an das Bussystem angeschlossen werden. Dadurch wird beispielsweise auch die Verwendung des Breakoutmoduls oder anderer Erweiterungsmodule wie z. B. des Energiemoduls im Gegenstecker zusammen mit dem Mastermodul des Steckverbinders ermöglicht. Insbesondere kann das Mastermodul über ein derartiges Breakoutmodul, wie oben beschrieben, auch die Slavemodule des Gegensteckers verwalten.

In einer weiteren vorteilhaften Ausgestaltung ist es vorgesehen, dass in jedem Slavemodul ein insbesondere nichtflüchtiger Datenspeicher angeordnet ist. In diesem Datenspeicher ist eine Tabelle abgelegt, durch welche der Wert des elektrischen Widerstands dem jeweils dazugehörigen Steckplatz im Modularrahmen zugeordnet ist. Dadurch kann jedes Slavemodul seine eigene Position im Modularrahmen selbst kennen. Insbesondere kann sich das Slavemodul dadurch selbst die entsprechende ID vergeben und diese bevorzugt auf eine entsprechende Anfrage hin an das Mastermodul kommunizieren. Auf diese Weise kann die unter Verfahrensschritt A.) beschriebene Adressierung gemäß dieser vorteilhaften Ausgestaltung alternativ oder ergänzend zur oben beschriebenen Variante stattfinden.

### Ausführungsbeispiel

Ein Ausführungsbeispiel der Erfindung ist in den Zeichnungen dargestellt und wird im Folgenden näher erläutert. Es zeigen:
- Fig. 1a,: b eine Ausführungsform eines dem Stand der Technik Entsprechenden Steckverbindermodularsystems,
- Fig. 2a: eine schematische Darstellung einer aus dem Stand der Technik bekannten Anordnung von Modulen in einem Modularrahmen;
- Fig. 2b: eine schematische Darstellung einer erfindungsgemäßen Anordnung von Modulen in einem Modularrahmen;
- Fig. 3a, b: Eine Vorderseite und eine Rückseite einer Leiterkarte mit Leiterbahnen und Anschlusspads;

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

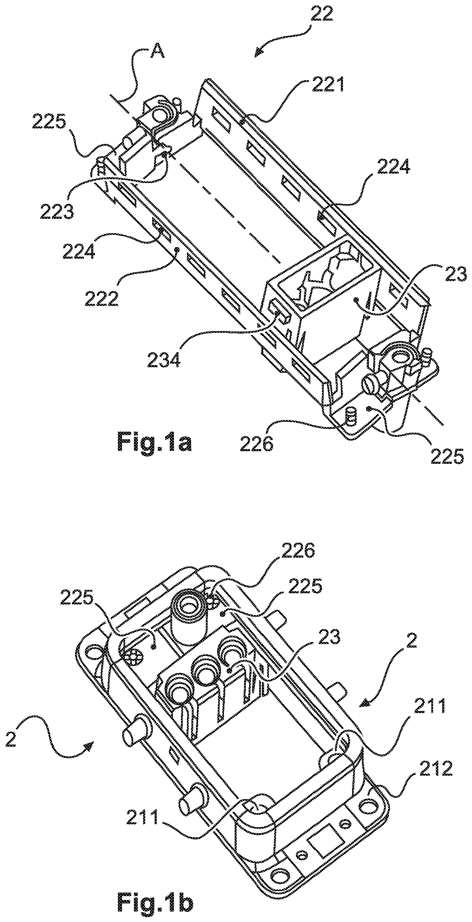

In den Fig. 1a und 1b ist vollständigkeitshalber ein dem Stand der Technik entsprechendes Steckverbindermodularsystem gezeigt, welches beispielhaft einen Modularrahmen aufweist, der als Gelenkrahmen 22 ausgeführt ist, wie er unter anderem aus der oben genannten Patentanmeldung EP 0 860 906 A2 im Stand der Technik bekannt ist.

Der Steckverbinder 2 umfasst somit ein Steckverbindergehäuse 21 und den besagten Gelenkrahmen 22.

Der Gelenkrahmen 22 ist nach dem Einfügen von Modulen, im Stand der Technik üblicherweise von konventionellen Steckverbindermodulen 23, zum Einbau in das Steckverbindergehäuse 21 oder zum Befestigen über einem Durchbruch einer Befestigungsfläche/Montagewand geeignet.

Der Gelenkrahmen 22 besteht aus zwei über Gelenke 223 verbundene Rahmenhälften mit Befestigungsenden 225, die mit Befestigungsschrauben 226 versehen sind. Die Gelenke 223 sind dabei an den Befestigungsenden 225 des Gelenkrahmens 22 vorgesehen, wobei die Schwenkmöglichkeit der Rahmenhälften quer zu den Seitenteilen 221, 222 des Gelenkrahmens 22 vorgesehen ist.

Zur Bildung der Gelenke 223 sind an den Befestigungsenden 225 des Gelenkrahmens 22 jeweils puzzleteilartige Anformungen vorgesehen, die in entsprechende Ausnehmungen eingreifen. Dabei werden diese Anformungen durch seitliches Verschieben der Seitenteile in die Ausnehmungen eingeschoben, wobei anschließend die Seitenteile um die Längsachse A schwenkbar (drehbar) sind.

In den Seitenteilen 221, 222 der Rahmenhälften sind Fenster 224 vorgesehen, in die die Rastzapfen 234 der jeweiligen Module 23 bei deren Einfügen in den Gelenkrahmen 22 eintauchen.

Zum Einfügen der Steckverbindermodule 2 wird der Halterahmen 2 aufgeklappt, d. h. geöffnet, wobei die Rahmenhälften 221, 222 um die Gelenke 223 so weit aufgeklappt werden, dass die Module 23 eingesetzt werden können.

Zur Fixierung werden die Rahmenhälften zusammengekappt und die beiden Seitenteile 221, 222 werden dabei parallel zueinander ausgerichtet, d. h. der Gelenkrahmen 22 wird geschlossen, wobei die jeweiligen Rastzapfen 234 der Steckverbindermodule 23 in die Fenster 224 gelangen und ein sicherer, formschlüssiger Halt der Module 23 in dem Gelenkrahmen 22 bewirkt wird.

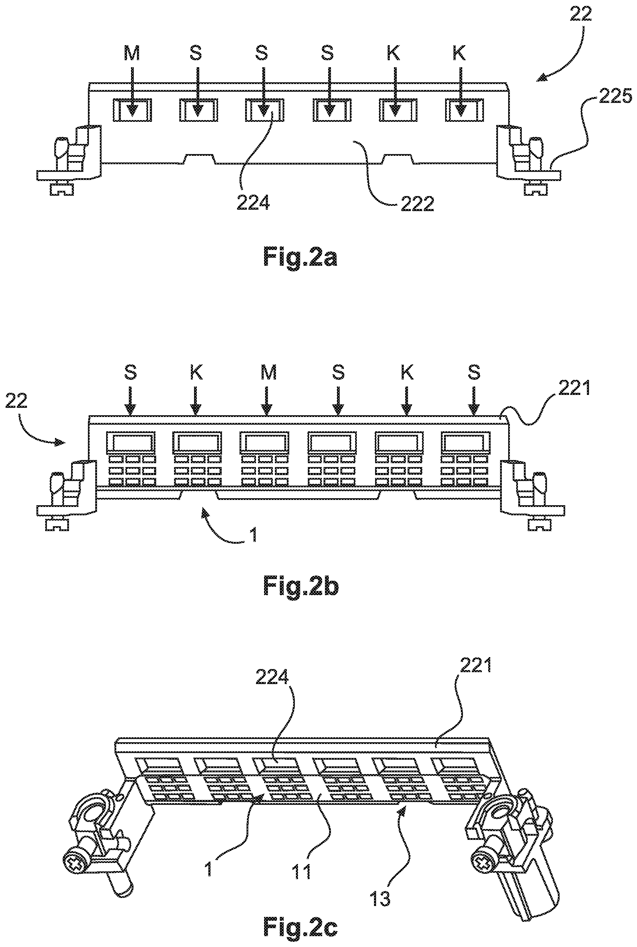

Schließlich ist in der Fig. 2b ein solcher Modularrahmen 22, eingesetzt in einem Steckverbindergehäuse 21, gezeigt. Dabei ist hier eine geschnittene Ansicht des Modularrahmens 22 gewählt, um Einzelheiten besser erkennen zu können. Durch das Aufschrauben des Modularrahmens 22 auf die in einer Befestigungsebene liegenden Befestigungsaugen 221 in den Gehäuseecken wird die geschlossene Stellung des Gelenkrahmens 22 endgültig fixiert.

Diese Ausführung dieses Steckverbindermodularsystems und des entsprechenden Modularrahmens ist beispielhaft erwähnt. Es ist in weiteren Ausführungen auch die Verwendung anders ausgeführter Modularrahmen möglich, welche die Module befestigen und so eine vergleichbare Funktion für das Steckverbindermodularsystem erfüllen.

Die Fig. 2 zeigt einen Modularrahmen 22 eines Steckverbinders oder zumindest Teile davon, wobei der Modularrahmen 22 in den Fig. 2a und 2b mit Modulen, nämlich einem Mastermodul M, drei Slavemodulen S und zwei herkömmlichen (d. h. "konventionellen") Modulen K bestückt werden soll. Die Verwendung der herkömmlichen Module K ist dabei insbesondere für die Abwärtskompatibilität eines solchen Steckverbindermodularsystems von großer wirtschaftlicher Bedeutung.

Gemäß dem Stand der Technik müssten die Slavemodule S direkt hintereinander angeordnet sein und direkt an das Mastermodul M anschließen, also in einer Anordnung, wie sie z. B. in der Fig. 2a angedeutet ist, um miteinander und dadurch auch mit dem Mastermodul zu kontaktieren. Die konventionellen Module befinden sich daher zwangsläufig am äußeren Ende des Modularrahmens 22 (hier rechts dargestellt). Diese Vorgabe führt aber oft zu Problemen mit einer ungeeigneten Belegung eines Gegensteckers, insbesondere wenn auch dieser Gegenstecker Slavemodule S aufweist. Schließlich werden diese üblicherweise mit den konventionellen Modulen K des Steckverbinders gesteckt und sind daher in ihrer Position entsprechenden Restriktionen ihres eigenen Steckverbindermodularsystems unterworfen. Im Stand der Technik ist es bei einem bekannten System somit schwierig, das Mastermodul M des Steckverbinders auch zur Verwaltung der Slavemodule S des Gegensteckers zu verwenden, da diese sich am jeweils anderen Ende des Modularrahmens befinden müssen. Weiterhin ist dabei die Unterscheidung der Module in männlich (Pinkontakte)/ und weiblich (Buchsen) zu berücksichtigen, insbesondere unter der Vorgabe, dass die Pinkontakte in der Regel nicht spannungsführend sein sollten. Somit ist es ggf. auch nicht immer möglich, z. B. die Slavemodule des Gegensteckers in den Modularrahmen des Steckverbinders umzusetzen.

Somit können die Restriktionen bezüglich der Belegung der einzelnen Modulsteckplätze im Stand der Technik zu erheblichen Problemen und zu einem erheblichen Mehraufwand führen.

Dagegen ist es somit wünschenswert, die Module in einer beliebigen Reihenfolge im Modularrahmen anordnen zu können.

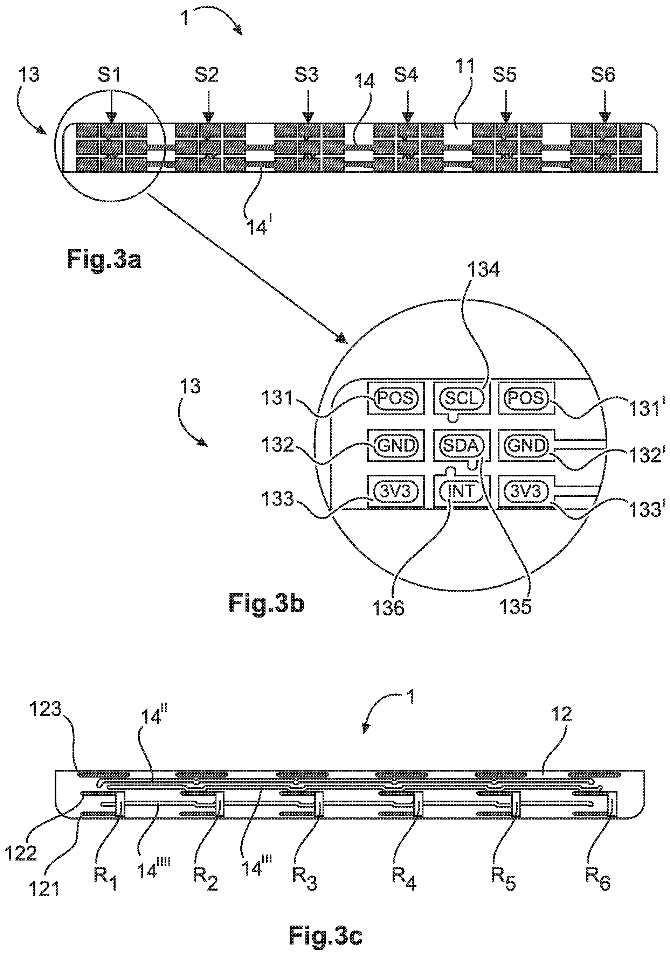

Die Fig. 2b zeigt einen erfindungsgemäßen Modularrahmen 22 im Querschnitt mit Blick auf die Innenseite eines langen Seitenteils 221, in das eine Leiterkarte 1 mit mindestens einem Datenbus integriert ist. Der Datenbus weist eine sich über das lange Seitenteil 221 in Längsrichtung erstreckende Leiterbahn, nämlich eine in der Fig. 3c besonders gut dargestellte Datenleiterbahn 14‴, zur elektronischen Datenübertragung auf.

Erfindungsgemäß können dadurch Module, welche die besagte Datenleiterbahn 14‴ elektrisch kontaktieren, frei angeordnet werden. Gleichzeitig können die Slavemodule S mit dem Mastermodul M im gegenseitigen Datenaustausch stehen.

Die Fig. 2c zeigt eine entsprechende Rahmenhälfte mit dem besagten Seitenteil 221 und der darin integrierten Leiterkarte 1 mit Blick auf deren Vorderseite 11 in einer 3D-Ansicht. Für jeden Modulsteckplatz ist auf der Leiterkarte 1 ein Satz von Anschlusspads 13 vorgesehen, welcher in der Zeichnung unterhalb des Fensters 224 des Seitenteils 221 dargestellt ist.

Die Fig. 3 zeigt die Leiterkarte 1 mit ihren Anschlusspads 13 und Leiterbahnen 14.

In der Fig. 3a ist die Vorderseite 11 der Leiterkarte 1 unter Andeutung der verschiedenen Modulsteckplätzen S1, S2, S3, S4, S5, S6 mit je einem dazugehörigen Satz von Kontaktpads 13 gezeigt, von denen in der Fig. 3b beispielhaft ein Satz von Anschlusspads 13 stellvertretend für alle anderen ausführlich bezeichnet ist.

Es sind jeweils zwei Positions-Pads 131, 131', zwei Masse-Pads 132, 132' und zwei Stromversorgungs-Pads 133, 133' je durch eine dazugehörige auf der Rückseite 12 der Leiterkarte 1 angeordnete Brücke 121, 122 und 123 elektrisch leitend miteinander verbunden. Dadurch sind sie auf der Vorderseite der Leiterkarte 1 mehrfach vorhanden und können beispielsweise so durch umgekehrt orientierte Module, wie im Folgenden beschrieben, besonders vorteilhaft kontaktiert werden.

Die Positionspads 131, 131' gestatten die Identifikation des jeweiligen Modulsteckplatzes durch eine im Folgenden erläuterte Widerstandskodierung. Die Massepads 132, 132' gestatten eine elektrisch leitende Verbindung zu einem definierten Massepotential für die Stromversorgung, das aber auch für andere Anwendungen, z. B. als Referenzspannung für ein Datensignal, nutzbar ist.

Die Fig. 3c zeigt die Rückseite 12 der Leiterkarte 1 mit der durchgehenden Datenleiterbahn 14‴ und einer dazu gehörigen Taktungsleiterbahn 14‴′, welche dafür vorgesehen ist, ein sogenanntes "Clocksignal" zur Taktung der Datenübertragung zu übertragen.

Die Leiterkarte 1 ist gegenüber den beiden vorangegangenen Darstellungen um 180° um eine horizontale Achse gedreht. Dadurch ist die zur Verbindung der Positionspads 131, 131' vorgesehene Brücke 121 in der Zeichnung unten angeordnet. Die zur Verbindung der Massepads 132, 132' vorgesehene Brücke 122 befindet sich in der Mitte und die zur Verbindung der Stromversorgungspads 133, 133' vorgesehene Brücke 123 befindet sich im oben dargestellten Bereich.

Durch die beiden letztgenannten Brücken 122, 123 sind die beiden weiteren zur Stromversorgung vorgesehenen Leiterbahnen 14, 14' (vgl. Fig. 3a) durchgehend ausgebildet. Bei der ersten weiteren Leiterbahn handelt es sich um eine Stromversorgungsleiterbahn 14'. Die zweite weitere Leiterbahn ist als Masseleiterbahn 14 vorgesehen und verbindet die Massepads 132, 132' der verschiedenen Modulsteckplätze S1, S2, S3, S4, S5, S6 elektrisch leitend miteinander.

Als zusätzliche durchgehende Leiterbahn ist eine Interruptleiterbahn 14" vorgesehen. Weiterhin ist an jedem Modulsteckplatz S1, S2, S3, S4, S5, S6 zur besagten Widerstandskodierung ein elektrischer Widerstand R1, R2, R3, R4, R5, R6 zwischen dem Widerstandspad und der Massebrücke geschaltet, wobei sich diese elektrischen Widerstände R1, R2, R3, R4, R5, R6 durch ihren Betrag signifikant voneinander unterscheiden, um so eine elektronische Identifikation des jeweiligen Modulsteckplatzes zu ermöglichen.

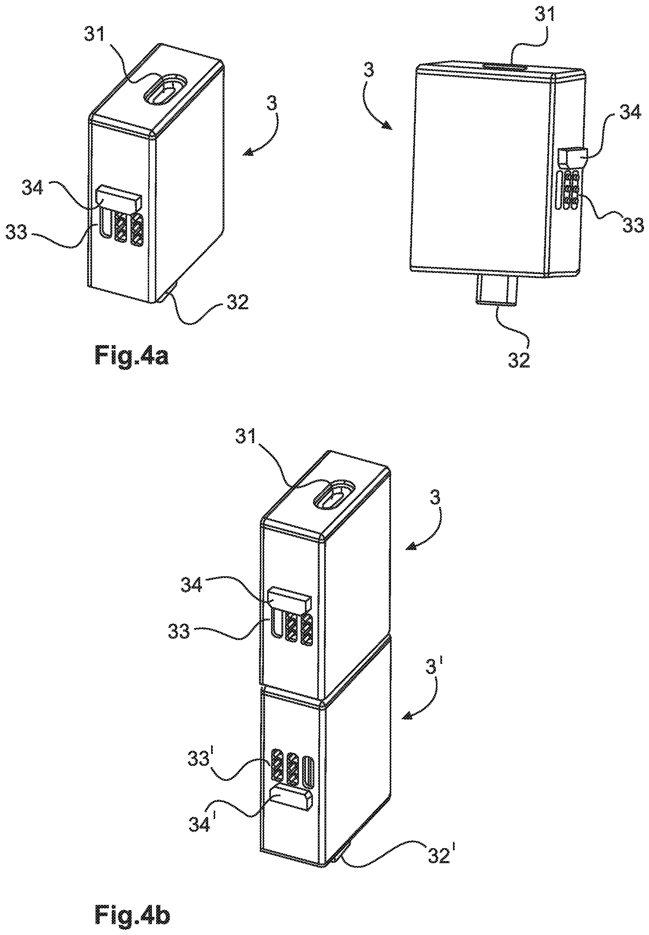

Die Fig. 4a zeigt ein Mastermodul 3 in zwei verschiedenen Ansichten. Das Mastermodul 3 besitzt an zwei einander gegenüberliegenden Stirnseiten die bereits beschriebenen Rastnasen 34, von denen in der Zeichnung nur eine zu sehen ist. Weiterhin besitzt das Mastermodul 3 kabelanschlussseitig eine USB-Buchse 31 und an einer gegenüberliegenden Steckseite einen USB-Stecker 32. Steckseitig der Rastnasen, also in der Zeichnung unterhalb, sind Buskontakte 33 dargestellt. Dabei ist auffällig, dass es sich lediglich um sechs Buskontakte handelt, von denen jeweils drei in einer Reihe angeordnet sind, wobei das Gehäuse aber serienmäßig eine weitere Ausnehmung für eine derartige Reihe, also insgesamt drei Reihen, vorsieht.

Dies dient dazu, die gleiche Gehäusebauform gegebenenfalls auch für das in der Fig. 4b dargestellte umgekehrt orientierte Modul zu verwenden.

Bei diesem Modul handelt es sich um das oben bereits erwähnte Breakoutmodul 3'. Es ist leicht erkennbar, dass das Mastermodul 3 mit seinem USB-Stecker 32 in die USB-Buchse des Breakoutmoduls 3' gesteckt ist. In gleicher Weise ließen sich aus weitere Slavemodule kaskadieren.

Das Breakoutmodul muss dazu steck- und anschlussseitig umgekehrt orientiert ausgeführt sein, d.h. die Buskontakte 33' befinden sich zwischen der Rastnase 33'und der nicht in der Zeichnung sichtbaren USB-Buchse des Breakoutmoduls 3'. Neben den beiden Kontaktreihen befindet sich die dritte, ungenutzte Reihe. Diese ist vorgesehen, um je nach Anforderung, bei bestimmten Slavemodulen die Kontaktreihe auch auf der anderen Seite anzuordnen, um so die Elektronik möglichst identisch zu gestalten um möglichst gleiche elektronische Bauteile zu verwenden. Beim vorliegenden Breakoutmodul 3' ist dies jedoch nicht notwendig.

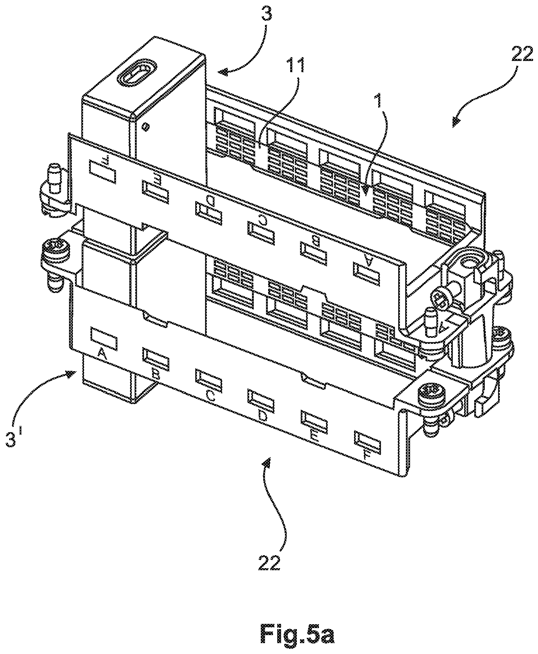

In der Fig. 5a sind diese beiden miteinander gesteckten Master- und Module 3, 3' in je einem Modularrahmen 22 eingefügt dargestellt wobei die beiden Modularrahmen 22 gleich ausgeführt und miteinander zusammengefügt sind.

Unter Einbeziehung der vorangegangenen Darstellung (vgl. Fig. 4b) ist es leicht ersichtlich, dass die erste Reihe der Buskontakte 33, 33' gleiche Pads 131, 132, 133 der jeweiligen Bussysteme kontaktiert. Würden die Buskontakte 33 des Breakout-Moduls 3' bauformbedingt die links dargestellte Kontaktreihe frei lassen und stattdessen die rechts dargestellte Kontaktöffnung nutzen, wie es bei einer Vielzahl von Slavemodulen der Fall ist, dann würden jeweils die anderen der parallelgeschalteten Paare der Pads 131', 132', 133' des jeweiligen Bussystems verwendet (vgl. Fig. 3b). Die Leiterkarte 1 ist diesbezüglich durch die Brückung mehrerer Anschlusspads flexibel. Gleichzeitig können dieselben Modularrahmen 22 unabhängig davon sowohl für den

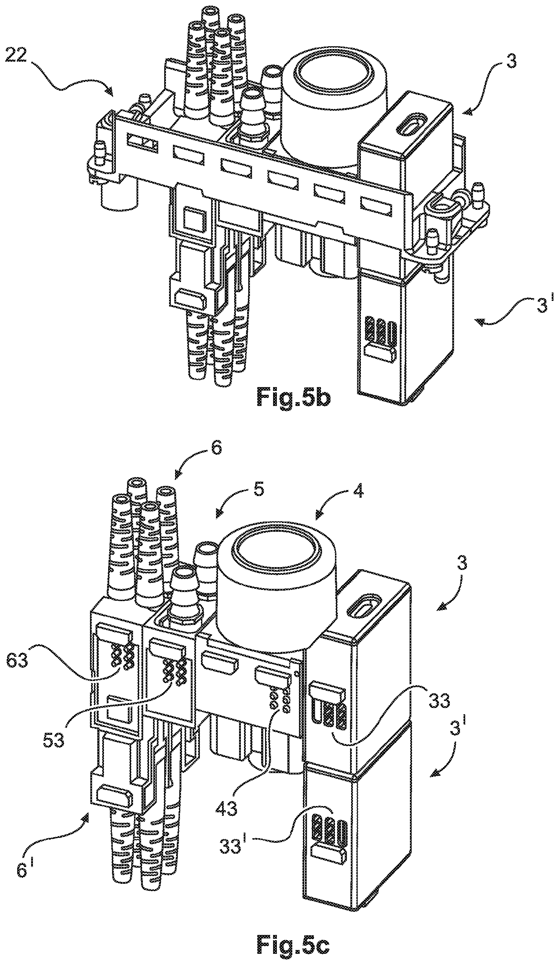

Steckverbinder als auch für den Gegenstecker verwendet werden. Die Fig. 5b und 5c zeigen eine Anordnung mehrerer Module 3, 3', 4, 5, 6, 6' in einem Steckverbindermodularsystem mit und ohne Halterahmen 22.

Als Module finden hier Verwendung: Ein Mastermodul 3, ein Breakoutmodul 3' zur Verbindung des Mastermoduls 3 mit dem Bussystem des hier nicht gezeigten Modularrahmens des Gegensteckers, ein Leistungsmodul 4 zur Messung der übertragenen elektrischen Leistung, ein pneumatisches ("Luftdruck"-) Modul 5 zur Kontrollmessung des dadurch übertragenen Luftdrucks sowie ein optisches Modul 6 zur Messung von Streulicht zur entsprechenden Fehleranalyse mit einem dazu gehörigen konventionellen optischen Gegenmodul 6'.

Die Slavemodule 4, 5, 6 sind mit ihren Buskontakten 43, 53, 63 an das Bussystem der Leiterkarte 1 angeschlossen und darüber parallel geschaltet an die Buskontakte 33 des Mastermoduls 3 angeschlossen. Das Breakoutmodul 3' ist mit seinen Buskontakten 33' an das Bussystem des Gegensteckers angeschlossen. Das Mastermodul 3 erhält entsprechende Daten/Signale über seinen USB-Stecker 32' vom daran angesteckten Breakoutmodul 3'.

### Bezugszeichenliste

- 1: Leiterkarte
- 11: Vorderseite der Leiterkarte
- 12: Rückseite der Leiterkarte
- 121: Brücke für Positions-Pads
- 122: Brücke für Masse-Pads
- 123: Brücke für Stromversorgungs-Pads
- 13: Satz von Anschlusspads
- 131, 131': Widerstands-Kontakt-Pads
- 132, 132': Masse-Pads
- 133, 133': Stromversorgungs-Pads
- 134: Taktungs-Pad (Clock)
- 135: Daten-Pad
- 136: Interrupt-Pad
- 14, 14', 14", 14‴, 14ʺʺ: durchgehende Leiterbahnen:
- 14: Masseleiterbahn
- 14': Stromversorgungsleiterbahn
- 14": Interruptleiterbahn
- 14‴: Datenleiterbahn
- 14ʺʺ: Taktungsleiterbahn (Clock)

- S1, S2, ..., S6: Modulsteckplätze

- R1, R2, ..., R6: verschiedene elektrische Widerstände

- M: Mastermodul
- S: Slavemodul
- K: herkömmliches ("konventionelles") Modul
- 2: Steckverbinder mit Steckverbindermodularsystem

- 21: Steckverbindergehäuse
- 211: Befestigungsaugen
- 212: Befestigungsflansch

- 22: Modularrahmen, Gelenkrahmen
- 221, 222: Seitenteile
- 223: Gelenk
- 224: Fenster
- 225: Befestigungsenden
- 226: Befestigungsschrauben

- 23: Steckverbindermodul
- 234: Rastzapfen des Steckverbindermoduls

- A: Längsachse

- 3: Mastermodul
- 3': Breakoutmodul
- 31, 31': USB-Buchse
- 32, 32': USB-Stecker
- 33, 33': Buskontakte
- 34, 34': Rastnasen

- 4: Leistungsmodul
- 43: Buskontakte des Leistungsmoduls
- 5: Druckluftmodul
- 53: Buskontakte des Druckluftmoduls
- 6: Lichtwellenleitermodul
- 63: Buskontakte des Lichtwellenleiermoduls

## Patentansprüche

1. Steckverbindermodularsystem, aufweisend Folgendes:
a. einen Modularrahmen (22) für einen Rechtecksteckverbinder, wobei der Modularrahmen (22) zwei einander gegenüberliegende langen Seitenteile (221, 222) besitzt;
b. ein Bussystem mit mindestens einem Datenbus, aufweisend mindestens eine sich über zumindest eine der beiden langen Seitenteile in Längsrichtung erstreckende Leiterbahn (14‴) zur elektronischen Datenübertragung;
c. ein im Modularrahmen (22) angeordnetes oder anzuordnendes Mastermodul (3) mit mindestens einem elektrischen Buskontakt (33) zum Senden von Anfragen und zum Empfang von Antworten über den Datenbus;
d. mehrere im Modularrahmen (22) angeordnete oder anzuordnende Slavemodule (4, 5, 6) mit jeweils mindestens einem elektrischen Buskontakt (43, 53, 63) zum Empfang von Anfragen des Mastermoduls (3) und zum Senden von Antworten an das Mastermodul (3);
**dadurch gekennzeichnet, dass**
e. das Mastermodul (3) und die Slavemodule (4, 5, 6) mit ihrem jeweils mindestens einen Buskontakt (43, 53, 63) über die mindestens eine Leiterbahn (14‴) in Form einer Parallelschaltung elektrisch leitend miteinander verbunden sind, wobei gleichzeitig
f. die Slavemodule (4, 5, 6) mit dem Mastermodul (3) über den Datenbus durch eine sternpunktförmige Datenübertragungsstruktur verbunden sind, wobei das Mastermodul (3) den Sternpunkt bildet, wobei
g. die besagten Leiterbahnen (14, 14', 14", 14‴, 14ʺʺ) in mindestens eine Leiterkarte (1) integriert sind und wobei die mindestens eine Leiterkarte (1) in oder an einer der beiden oder beiden langen Seitenteilen (221) innerhalb des Modularrahmens (2) angebracht ist und wobei jede der besagten Leiterbahnen (14, 14', 14", 14‴, 14"") zur Kontaktierung der Buskontakte (33, 33', 43, 53, 63) sowohl der Slavemodule (4, 5, 6) als auch des Mastermoduls (3) jeweils zumindest ein Kontaktpad (131, 131', 132, 132', 133, 133', 134, 135, 136) und/oder einen Kontaktierungsbereich aufweist.

2. Steckverbindermodularsystem gemäß Anspruch 1, wobei der in Punkt b besagte Datenbus mindestens zwei Leiterbahnen (14‴, 14ʺʺ) besitzt, wobei eine erste dieser Leiterbahnen (14‴) zur eigentlichen Übertragung der Daten und eine zweite Leiterbahn (14ʺʺ) zur Taktung ("Clock") vorgesehen ist.

3. Steckverbindermodularsystem gemäß einem der vorstehenden Ansprüche, wobei es sich bei dem Datenbus um einen sogenannten "Master-Slave-Bus" handelt.

4. Steckverbindermodularsystem gemäß einem der vorstehenden Ansprüche, wobei das Mastermodul (3) eine Auswertelektronik mit einer Steuerelektronik zur Regelung der Datenübertragung auf dem Datenbus besitzt, um damit die im Steckverbindermodularsystem aufgenommenen Slavemodule (4, 5, 6) zu erkennen, ihre Identifikationsnummer (ID) ihrer jeweiligen geometrischen Position im Modularrahmen (22) zuzuordnen und weiterhin Messwerte von in den Slavemodulen (4, 5, 6) angeordneten Sensoren dem jeweiligen Slavemodul (4, 5, 6) zu übertragen, zuzuordnen und entsprechend zu verarbeiten.

5. Steckverbindermodularsystem nach Anspruch 5, wobei das Mastermodul (3) weiterhin eine externe Netzwerkschnittstelle besitzt, um darüber zumindest einige der Messwerte und/oder daraus berechnete Größen in Form von Messdaten an ein externes Netzwerk weiterzugeben.

6. Steckverbindermodularsystem nach einem der vorstehenden Ansprüche, wobei das Steckverbindermodularsystem weiterhin zumindest zwei weitere Leiterbahnen (14, 14') zur Stromversorgung der Slavemodule (4, 5, 6) und/oder des Mastermoduls (3) besitzt.

7. Steckverbindermodularsystem nach Anspruch 6, wobei eine der beiden weiteren Leiterbahnen (14') im Betrieb stromführend ist und die andere Leiterbahn Massepotential (14) besitzt.

8. Steckverbindermodularsystem nach Anspruch 7, wobei an der Einsteckposition jedes Slavemoduls (4, 5, 6) je ein elektrischer Widerstand (R1, R2, R3, R4, R5, R6) angeordnet ist und zwischen einem Widerstands-Kontaktpad (131, 131') und der Massepotential führenden weiteren Leiterbahn (14) geschaltet ist, wobei sich diese elektrischen Widerstände (R1, R2, R3, R4, R5, R6) signifikant voneinander unterscheiden, um eine elektronische Identifikation der Einsteckposition des jeweiligen Slavemoduls (4, 5, 6) zu ermöglichen.

9. Steckverbindermodularsystem nach einem der vorstehenden Ansprüche, wobei das Steckverbindermodularsystem außerdem zumindest eine zusätzliche Leiterbahn (14") als Interruptleitung aufweist, um es zu ermöglichen, dass jedes Slavemodul (4, 5, 6) das Mastermodul (3) schnellstmöglich und aktiv auf das Vorhandensein eines Fehlerzustands hinweisen kann.

10. Steckverbindermodularsystem nach Anspruch 9, wobei die Leiterkarte (1) formschlüssig in einer Ausnehmung des entsprechenden Seitenteils (221) angeordnet ist.

11. Messverfahren zum Messen einer Messgröße in mindestens einem Slavemodul (4, 5, 6) eines Steckverbindermodularsystems gemäß dem Anspruch 1 und zum Übertragen entsprechender Messdaten vom Slavemodul (4, 5, 6) an ein Mastermodul (3) des Steckverbindermodularsystems gemäß dem Anspruch 1 mit folgenden Schritten:
A.) Das Mastermodul (3) adressiert mehrere Slavemodule (4, 5, 6) gemäß der Steckposition des jeweiligen Slavemoduls (4, 5, 6) in einem Modularrahmen (22);
B.) das Mastermodul (3) fordert von den Slavemodulen (4, 5, 6) über einen Datenbus jeweils eine Kennung an;
C.) die Slavemodule (4, 5, 6) übertragen ihre jeweilige Kennung über den Datenbus an das Mastermodul (3);
D.) das Mastermodul (3) erkennt die Art des jeweiligen Slavemoduls (4, 5, 6) anhand dessen Kennung;
E.) das Mastermodul (3) lädt jeweils ein zur Art des Slavemoduls (4, 5, 6) passendes Softwareprogramm aus einer externen Quelle;
F.) das Mastermodul (3) speichert die Softwareprogramme in einem kombinierten Programm/Datenspeicher ab;
G.) das Mastermodul (3) lässt die jeweiligen Softwareprogramme über einen zum Mastermodul (3) gehörenden Mikroprozessor ausführen, indem es einzelne Anweisungen über den Datenbus an das Slavemodul (4, 5, 6) überträgt;
∘ G1) das Mastermodul (3) lässt seinen Mikroprozessor zumindest ein Softwareprogramm ausführen, das zumindest ein Slavemodul (4, 5, 6) zum Messen zumindest einer Messgröße und zum Vorhalten entsprechender Messdaten veranlasst;
H.) das Mastermodul (3) fragt über den Datenbus die Messdaten vom jeweiligen Slavemodul (4, 5, 6) ab;
I.) das jeweilige Slavemodul (4, 5, 6) sendet die angefragten Messdaten an das Mastermodul (3);
J.) das Mastermodul (3) speichert die Messdaten als dem Slavemodul (4, 5, 6) zugehörig im kombinierten Programm/Datenspeicher ab.

12. Messverfahren gemäß Anspruch 11, wobei der Schritt A folgende Unterschritte aufweist:
A1) Die Slavemodule (4, 5, 6) kontaktieren mit ihren Buskontakten (43, 53, 63) jeweils einen an ihrer jeweiligen Einsteckposition angeordneten elektrischen Widerstand (R1, R2, R3, R4, R5, R6), wobei sich die elektrischen Widerstände (R1, R2, R3, R4, R5, R6) der verschiedenen Einsteckpositionen signifikant voneinander unterscheiden;
A2) das jeweilige Slavemodul (4, 5, 6) misst den an seiner Einsteckposition angeordneten elektrischen Widerstand (R1, R2, R3, R4, R5, R6);
A3) das Mastermodul (3) fragt über den Datenbus einen entsprechenden Messwert von jedem Slavemodul (4, 5, 6) ab;
A4) das Mastermodul (3) ordnet den Slavemodulen (4, 5, 6) eine ihrer jeweiligen Einsteckposition entsprechende Identifikationsnummer (ID) zu;
A5) das Mastermodul (3) speichert die Identifikationsnummer (ID) als dem jeweiligen Slavemodul (4, 5, 6) zugehörig in seinem kombinierten Programm/Datenspeicher ab.

13. Messverfahren gemäß einem der Ansprüche 11 bis 12, wobei das Mastermodul (3) mittels eines in seinem kombinierten Programm-/Datenspeicher abgelegten Datenprotokoll und seinem Mikroprozessor den Datenverkehr auf dem Datenbus folgendermaßen steuert:
- Das Mastermodul (3) sendet eine Anfrage über den Datenbus an jeweils eines der Slavemodule (4, 5, 6) und schließt die Anfrage erkennbar ab;
- das angefragte Slavemodul (4, 5, 6) sendet daraufhin über den Datenbus eine Antwort an das Mastermodul (3), während alle anderen Slavemodule (4, 5, 6) schweigen.

14. Messverfahren gemäß einem der Ansprüche 11 bis 13, wobei es sich beider unter Punkt E erwähnten externen Quelle um ein externes Netzwerk handelt und wobei das externe Netzwerk folgendermaßen mit den Slavemodulen (4, 5, 6) kommuniziert:
- Das Mastermodul (3) erhält vom externen Netzwerk für jedes Slavemodul (4, 5, 6) eine externe Identifikationsnummer;
- das Mastermodul (3) speichert die externe Identifikationsnummer als dem jeweiligen Slavemodul (4, 5, 6) zugehörig in seinem kombinierten Programm-/Datenspeicher ab;
- das externe Netzwerk kommuniziert über die externe Identifikationsnummer mit der Software des jeweiligen Slavemoduls (4, 5, 6), wobei
- das Mastermodul (3) dem externen Netzwerk gegenüber das Slavemodul (4, 5, 6) simuliert, während der physikalische Datenaustausch tatsächlich zwischen dem externen Netzwerk und dem Mastermodul (3) stattfindet.

15. Messverfahren gemäß einem der Ansprüche 11 bis 14, wobei das Verfahren bei Auftreten eines Fehlerzustandes folgende Schritte vorsieht:
- Ein Sensor eines Slavemoduls (4, 5, 6) erzeugt einen sogenannten "Interrupt" und legt dazugehörige Informationen in einem dafür vorgesehenen Interrupt-Service-Register ab;
- der Interrupt wird in Form eines elektrischen Alarmsignals über eine eigens dafür vorgesehene Interruptleitung an das Mastermodul (3) gesendet;
- das vom Mastermodul (3) zu diesem Zeitpunkt gerade ausgeführte Softwareprogramm wird dadurch möglichst schnell zwischenzeitig unterbrochen und das Mastermodul (3) führt stattdessen zunächst eine sogenannte "Interrupt-Service-Routine" (ISR) aus;
- in der ISR fragt das Mastermodul (3) über den Datenbus die Interrupt-Service-Register sämtlicher Slavemodule (4, 5, 6) ab;
- das Mastermodul (3) findet so das fehlerbehaftete Slavemodul (4, 5, 6), und erfährt aus dem Interrupt-Sevice-Register weitere Informationen über den Fehlerzustand;
- Das Mastermodul (3) unternimmt gemäß seinem Softwareprogramm für den jeweiligen Fehlerzustand vorgesehenen weitere Schritte.

## Claims

1. Plug connector modular system having the following:
a. a modular frame (22) for a rectangular plug connector, wherein the modular frame (22) has two long side parts (221, 222) opposite one another;
b. a bus system having at least one data bus, having at least one conductor track (14‴) for electronic data transmission that extends over at least one of the two long side parts in the longitudinal direction;
c. a master module (3) which is arranged or can be arranged in the modular frame (22) and has at least one electrical bus contact (33) for transmitting requests and for receiving responses via the data bus;
d. a plurality of slave modules (4, 5, 6) which are arranged or can be arranged in the modular frame (22) and each have at least one electrical bus contact (43, 53, 63) for receiving requests from the master module (3) and for transmitting responses to the master module (3);
**characterized in that**
e. the master module (3) and the slave modules (4, 5, 6) are connected to one another in an electrically conductive manner in the form of a parallel circuit by way of their respective at least one bus contact (43, 53, 63) via' the at least one conductor track (14‴), wherein at the same time
f. the slave modules (4, 5, 6) are connected to the master module (3) via the data bus by way of a data transmission structure in the form of a star point, wherein the master module (3) forms the star point, wherein
g. said conductor tracks (14, 14', 14", 14‴, 14ʺʺ) are integrated in at least one circuit board (1), and wherein the at least one circuit board (1) is fitted in or on one of the two or in or on both long side parts (221) within the modular frame (2), and wherein each of said conductor tracks (14, 14', 14", 14‴, 14ʺʺ) respectively has at least one contact pad (131, 131', 132, 132', 133, 133', 134, 135, 136) and/or one contacting region for the purpose of making contact with the bus contacts (33, 33', 43, 53, 63) of both the slave modules (4, 5, 6) and the master module (3).

2. Plug connector modular system according to Claim 1, wherein the data bus mentioned in point b has at least two conductor tracks (14‴, 14ʺʺ), wherein a first one of these conductor tracks (14‴) is provided for the purpose of actually transmitting the data and a second conductor track (14ʺʺ) is provided for clocking.

3. Plug connector modular system according to one of the preceding claims, wherein the data bus is a so-called "master-slave bus".

4. Plug connector modular system according to one of the preceding claims, wherein the master module (3) has evaluation electronics with control electronics for regulating the transmission. of data on the data bus in order to therefore identify the slave modules (4, 5, 6) accommodated in the plug connector modular system, to assign their identification number (ID) to their respective geometrical position in the modular frame (22) and to also transmit measured values from sensors arranged in the slave modules (4, 5, 6) to the respective slave module (4, 5, 6), to assign and accordingly process said measured values.

5. Plug connector modular system according to Claim 5, wherein the master module (3) also has an external network interface in order to forward at least some of the measured values and/or variables calculated therefrom in the form of measurement data to an external network via said interface.

6. Plug connector modular system according to one of the preceding claims, wherein the plug connector modular system also has at least two further conductor tracks (14, 14') for supplying power to the slave modules (4, 5, 6) and/or to the master module (3).

7. Plug connector modular system according to Claim 6, wherein one of the two further conductor tracks (14') is live during operation and the other conductor track has earth potential (14).

8. Plug connector modular system according to Claim 7, wherein an electrical resistor (R1, R2, R3, R4, R5, R6) is arranged at the insertion position of each slave module (4, 5, 6) and is connected between a resistor contact pad (131, 131') and the further conductor track (14) carrying earth potential, wherein these electrical resistors (R1, R2, R3, R4, R5, R6) differ significantly from one another in order to make it possible to electronically identify the insertion position of the respective slave module (4, 5, 6).

9. Plug connector modular system according to one of the preceding claims, wherein the plug connector modular system also has at least one additional conductor track (14") as an interrupt line in order to make it possible for each slave module (4, 5, 6) to be able to make the master module (3) aware of the presence of a fault state as quickly as possible and actively.

10. Plug connector modular system according to Claim 9, wherein the circuit board (1) is arranged in a form-fitting manner in a recess of the corresponding side part (221).

11. Measurement method for measuring a measurement variable in at least one slave module (4, 5, 6) of a plug connector modular system according to Claim 1 and for transmitting corresponding measurement data from the slave module (4, 5, 6) to a master module (3) of the plug connector modular system according to Claim 1, having the following steps:
A.) the master module (3) addresses a plurality of slave modules (4, 5, 6) according to the plugged position of the respective slave module (4, 5, 6) in a modular frame (22);
B.) the master module (3) requests a respective identifier from the slave modules (4, 5, 6) via a data bus;
C.) the slave modules (4, 5, 6) transmit their respective identifier to the master module (3) via the data bus;
D.) the master module (3) recognizes the type of the respective slave module (4, 5, 6) on the basis of its identifier;
E.) the master module (3) respectively loads a software program suitable for the type of slave module (4, 5, 6) from an external source;
F.) the master module (3) stores the software programs in a combined program/data memory;
G.) the master module (3) allows the respective software programs to be executed via a microprocessor belonging to the master module (3) by transmitting individual instructions to the slave module (4, 5, 6) via the data bus;
o G1) the master module (3) allows its microprocessor to execute at least one software program which causes at least one slave module (4, 5, 6) to measure at least one measurement variable and to hold corresponding measurement data;
H.) the master module (3) requests the measurement data from the respective slave module (4, 5, 6) via the data bus;
I.) the respective slave module (4, 5, 6) transmits the requested measurement data to the master module (3);
J.) the master module (3) stores the measurement data as belonging to the slave module (4, 5, 6) in the combinedprogram/data memory.

12. Measurement method according to Claim 11, wherein step A comprises the following sub-steps:
A1) the slave modules (4, 5, 6) each make contact, by way of their bus contacts (43, 53, 63), with an electrical resistor (R1, R2, R3, R4, R5, R6) arranged at their respective insertion position, wherein the electrical resistors (R1, R2, R3, R4, R5, R6) of the various insertion positions differ significantly from one another;
A2) the respective slave module (4, 5, 6) measures the electrical resistor (R1, R2, R3, R4, R5, R6) arranged at its insertion position;
A3) the master module (3) requests a corresponding measured value from each slave module (4, 5, 6) via the data bus;
A4) the master module (3) assigns the slave modules (4, 5, 6) an identification number (ID) corresponding to their respective insertion position;
A5) the master module (3) stores the identification number (ID) as belonging to the respective slave module (4, 5, 6) in its combined program/data memory.

13. Measurement method according to one of Claims 11 to 12, wherein the master module (3) controls the data traffic on the data bus using a data protocol stored in its combined program/data memory and its microprocessor as follows:
- the master module (3) transmits a request to one of the slave modules (4, 5, 6) in each case via the data bus and discernibly concludes the request;
- the requested slave module (4, 5, 6) then transmits a response to the master module (3) via the data bus, while all other slave modules (4, 5, 6) are silent.

14. Measurement method according to one of Claims 11 to 13, wherein both external sources mentioned in point E are an external network, and wherein the external network communicates with the slave modules (4, 5, 6) as follows:
- the master module (3) receives an external identification number for each slave module (4, 5, 6) from the external network;
- the master module (3) stores the external identification number as belonging to the respective slave module (4, 5, 6) in its combined program/data memory;
- the external network communicates with the software of the respective slave module (4, 5, 6) using the external identification number, wherein
- the master module (3) simulates the external network with respect to the slave module (4, 5, 6), while the physical interchange of data actually takes place between the external network and the master module (3).

15. Measurement method according to one of Claims 11 to 14, wherein the method provides the following steps when a fault state occurs:
- a sensor of a slave module (4, 5, 6) generates a so-called "interrupt" and stores associated information in an interrupt service register provided for this purpose;
- the interrupt is transmitted in the form of an electrical alarm signal to the master module (3) via an interrupt line specifically provided for this purpose;
- the software program currently being executed by the master module (3) at this time is thereby temporarily interrupted as quickly as possible and the master module (3) instead first of all executes a so-called "interrupt Service Routine" (ISR) ;
- in the ISR, the master module (3) queries the interrupt service register of all slave modules (4, 5, 6) via the data bus;
- the master module (3) therefore finds the faulty slave module (4, 5, 6) and finds out further information relating to the fault state from the interrupt service register;
- the master module (3) carries out further steps provided for the respective fault state according to its software program.

## Revendications

1. Système modulaire de connecteurs enfichables, présentant ce qui suit :
a) un cadre modulaire (22) pour un connecteur enfichable rectangulaire, le cadre modulaire (22) comportant deux parties latérales longues (221, 222) opposées l'une à l'autre ;
b) un système de bus pourvu d'au moins un bus de données, présentant au moins une piste conductrice (14‴) s'étendant sur au moins l'une des deux parties latérales longues dans la direction longitudinale pour la transmission de données électroniques ;
c) un module maître (3) disposé ou à disposer dans le cadre modulaire (22) et pourvu d'au moins un contact de bus électrique (33) pour envoyer des demandes et pour recevoir des réponses par l'intermédiaire du bus de données ;
d) plusieurs modules esclaves (4, 5, 6) disposés ou à disposer dans le cadre modulaire (22) et pourvus respectivement d'au moins un contact de bus électrique (43, 53, 63) pour recevoir des demandes du module maître (3) et pour envoyer des réponses au module maître (3) ;
**caractérisé en ce que**
e) le module maître (3) et les modules esclaves (4, 5, 6) sont reliés les uns aux autres de manière électriquement conductrice, respectivement par leur au moins un contact de bus (43, 53, 63), par l'intermédiaire de ladite au moins une piste conductrice (14''') sous la forme d'un montage en parallèle, dans lequel en même temps
f) les modules esclaves (4, 5, 6) sont reliés au module maître (3) par l'intermédiaire du bus de données par une structure de transmission de données en forme de point neutre, le module maître (3) formant le point neutre, dans lequel
g) lesdites pistes conductrices (14, 14', 14", 14''', 14"") sont intégrées dans au moins une carte de circuits imprimés (1), et dans lequel ladite au moins une carte de circuits imprimés (1) est fixée dans ou sur l'une des deux, ou les deux, parties latérales longues (221) à l'intérieur du cadre modulaire (2), et dans lequel chacune desdites pistes conductrices (14, 14', 14", 14‴, 14ʺʺ) présente pour la mise en contact des contacts de bus (33, 33', 43, 53, 63) aussi bien desmodules esclaves (4, 5, 6) que du module maître (3) respectivement au moins un plot de contact (131, 131', 132, 132', 133, 133', 134, 135, 136) et/ou une zone de mise en contact.

2. Système modulaire de connecteurs enfichables selon la revendication 1, dans lequel le bus de données mentionné au point b) comporte au moins deux pistes conductrices (14‴, 14ʺʺ), dans lequel une première de ces pistes conductrices (14‴) est prévue pour la transmission proprement dite des données, et une deuxième piste conductrice (14"") est prévue pour la synchronisation (horloge).

3. Système modulaire de connecteurs enfichables selon l'une quelconque des revendications précédentes, dans lequel le bus de données est un bus dit « bus maître/esclave ».

4. Système modulaire de connecteurs enfichables selon l'une quelconque des revendications précédentes, dans lequel le module maître (3) comporte une électronique d'évaluation pourvue d'une électronique de commande pour réguler la transmission de données sur le bus de données afin d'identifier de ce fait les modules esclaves (4, 5, 6) reçus dans le système modulaire de connecteurs enfichables, pour associer leur numéro d'identification (ID) à leur position géométrique respective dans le cadre modulaire (22), et de plus pour transmettre des valeurs de mesure provenant de capteurs disposés dans les modules esclaves (4, 5, 6) au module esclave (4, 5, 6) respectif, pour les associer et pour les traiter en conséquence.

5. Système modulaire de connecteurs enfichables selon la revendication 5, dans lequel le module maître (3) comporte en outre une interface de réseau externe afin de retransmettre à un réseau externe par l'intermédiaire de celle-ci au moins certaines des valeurs de mesure et/ou des grandeurs calculées à partir de celles-ci sous forme de données de mesure.

6. Système modulaire de connecteurs enfichables selon l'une quelconque des revendications précédentes, dans lequel le système modulaire de connecteurs enfichables comporte en outre au moins deux autres pistes conductrices (14, 14') pour l'alimentation électrique des modules esclaves (4, 5, 6) et/ou du module maître (3) .

7. Système modulaire de connecteurs enfichables selon la revendication 6, dans lequel l'une des deux autres pistes conductrices (14') est électriquement conductrice en cours de fonctionnement, et l'autre piste conductrice comporte un potentiel de masse (14).

8. Système modulaire de connecteurs enfichables selon la revendication 7, dans lequel respectivement une résistance électrique (R1, R2, R3, R4, R5, R6) est disposée à la position d'enfichage de chaque module esclave (4, 5, 6) et est connectée entre un plot de contact de résistance (131, 131') et l'autre piste conductrice (14) conduisant le potentiel de masse, dans lequel ces résistances électriques (R1, R2, R3, R4, R5, R6) se distinguent nettement les unes des autres afin de permettre une identification électronique de la position d'insertion du module esclave (4, 5, 6) respectif.

9. Système modulaire de connecteurs enfichables selon l'une quelconque des revendications précédentes, dans lequel le système modulaire de connecteurs enfichables présente en outre au moins une piste conductrice supplémentaire (14") comme une ligne d'interruption afin de permettre à chaque module esclave (4, 5, 6) d'informer le module maître (3) aussi vite que possible et activement de la présence d'un état de défaut.

10. Système modulaire de connecteurs enfichables selon la revendication 9, dans lequel la carte de circuits imprimés (1) est disposée par complémentarité de forme dans un évidement de la partie latérale correspondante (221).

11. Procédé de mesure permettant de mesurer une grandeur de mesure dans au moins un module esclave (4, 5, 6) d'un système modulaire de connecteurs enfichables selon la revendication 1 et pour, transmettre des données de mesure correspondantes du module esclave (4, 5, 6) à un module maître (3) du système modulaire de connecteurs enfichables selon la revendication 1, comprenant les étapes suivantes :
A) le module maître (3) adresse plusieurs modules esclaves (4, 5, 6) selon la position d'enfichage du module esclave (4, 5, 6) respectif dans un cadre modulaire (22) ;
B) le module maître (3) demande aux modules esclaves (4, 5, 6) respectivement un identifiant par l'intermédiaire d'un bus de données ;
C) les modules esclaves (4, 5, 6) transmettent leur identifiant respectif au module maître (3) par l'intermédiaire du bus de données ;
D) le module maître(3) identifie le type du module esclave (4, 5, 6) respectif à l'aide de l'identifiant de celui-ci ;
E) le module maître (3) charge respectivement un programme informatique adapté au type du module esclave (4, 5, 6) à partir d'une source externe ;
F) le module maître (3) stocke les programmes informatiques dans une mémoire combinée de programmes/données ;
G) le module maître (3) provoque l'exécution des programmes informatiques respectifs par l'intermédiaire d'un microprocesseur appartenant au module maître (3) en transmettant des instructions individuelles au module esclave (4, 5, 6) par l'intermédiaire du bus de données ;
∘ G1) le module maître (3) fait que son microprocesseur exécute au moins un programme informatique qui amène au moins un module esclave (4, 5, 6) à mesurer au moins une grandeur de mesure et à fournir des données de mesure correspondantes ;
H) le module maître (3) interroge des données de mesure du module esclave (4, 5, 6) respectif par l'intermédiaire du bus de données ;
I) le module esclave (4, 5, 6) respectif envoie les données de mesure demandées au module maître (3) ;
J) le module maître (3) stocke les données de mesure comme étant associées au module esclave (4, 5, 6) dans la mémoire combinée de programme/données.

12. Procédé de mesure selon la revendication 11, dans lequel l'étape A présente les sous-étapes suivantes :
A1) les modules esclaves (4, 5, 6) contactent par leurs contacts de bus (43, 53, 63) respectivement une résistance électrique (R1, R2, R3, R4, R5, R6) disposée dans sa position d'enfichage respective, dans lequel les résistances électriques (R1, R2, R3, R4, R5, R6) des différentes positions d'enfichage se distinguent nettement les unes des autres ;
A2) le module esclave (4, 5, 6) respectif mesure la résistance électrique (R1, R2, R3, R4, R5, R6) disposée à sa position d'enfichage ;
A3) le module maître (3) interroge par l'intermédiaire du bus de données une valeur de mesure correspondante de chaque module esclave (4, 5, 6) ;
A4) le module maître (3) attribue aux modules esclaves (4, 5, 6) un numéro d'identification (ID) correspondant à leur position d'enfichage respective ;
A5) le module maître (3) stocke le numéro d'identification (ID) comme étant associé au module esclave (4, 5, 6) respectif dans sa mémoire combinée de programme/données.

13. Procédé de mesure selon l'une quelconque des revendications 11 à 12, dans lequel le module maître (3) commande au moyen d'un protocole de données mémorisé dans sa mémoire combinée de programme/données et de son microprocesseur le trafic de données sur le bus de données de la manière suivante :
- le module maître (3) envoie une demande par l'intermédiaire du bus de données respectivement à l'un des modules esclaves (4, 5, 6) et termine la demande de manière identifiable ;
- le module esclave (4, 5, 6) demandé envoie alors par l'intermédiaire du bus de données une réponse au module maître (3) pendant que tous les autres modules esclaves (4, 5, 6) sont silencieux.

14. Procédé de mesure selon l'une quelconque des revendications 11 à 13, dans lequel la source externe mentionnée au point E) est un réseau externe, et dans lequel le réseau externe communique avec les modules esclaves (4, 5, 6) de la manière suivante :
le module maître (3) reçoit du réseau externe pour chaque module esclave (4, 5, 6) un numéro d'identification externe ;
- le module maître (3) stocke le numéro d'identification externe comme étant associé au module esclave (4, 5, 6) respectif dans sa mémoire combinée de programme/données ;
- le réseau externe communique par l'intermédiaire du numéro d'identification externe avec le programme informatique du module esclave (4, 5, 6) respectif, dans lequel
- le module maître (3) simule par rapport au réseau externe le module esclave (4, 5, 6) pendant que l'échange de données réel a lieu effectivement entre le réseau externe et le module maître (3).

15. Procédé de mesure selon l'une quelconque des revendications 11 à 14, dans lequel le procédé prévoit les étapes suivantes en cas d'apparition d'un état de défaut :
- un capteur d'un module esclave (4, 5, 6) génère une interruption et mémorise des informations associées dans un registre de service d'interruption prévu à cet effet ;
- l'interruption est envoyée au module maître (3) sous la forme d'un signal d'alarme électrique par l'intermédiaire d'une ligne d'interruption spécifiquement prévue à cet effet ;
- le programme informatique en cours d'exécution à cet instant par le module maître (3) est de ce fait interrompu entre-temps aussi vite que possible, et le module maître (3) exécute au lieu de cela d'abord une routine de service d'interruption, dite « interrupt service routine », ISR ;
dans l'ISR, le module maître (3) interroge les registres de service d'interruption de tous les modules esclaves (4, 5, 6) par l'intermédiaire du bus de données ;
- le module maître (3) trouve ainsi le module esclave défectueux (4, 5, 6), et apprend du registre de service d'interruption d'autres informations concernant l'état de défaut ;
- le module maître (3) effectue selon son programme informatique les autres étapes prévues pour l'état de défaut respectif.
